(19) Europäisches Patentamt
European Patent Office
Office européen des brevets

(11) EP 4 210 073 B1

(12) EUROPEAN PATENT SPECIFICATION

(45) Date of publication and mention of the grant of the patent:
**22.10.2025 Bulletin 2025/43**

(21) Application number: **21864444.1**

(22) Date of filing: **03.09.2021**

(51) International Patent Classification (IPC):
***H01B 13/00*** *(2006.01)* ***H05K 3/10*** *(2006.01)*
***B22F 3/105*** *(2006.01)*

(52) Cooperative Patent Classification (CPC):
(C-Sets available)
**B22F 1/107; H05K 3/105;** B22F 10/10; B22F 12/41; B22F 2998/10; B22F 2999/00; B33Y 10/00; B33Y 30/00; C22C 1/0425; H05K 2203/107; H05K 2203/1136 (Cont.)

(86) International application number:
**PCT/JP2021/032517**

(87) International publication number:
**WO 2022/050392 (10.03.2022 Gazette 2022/10)**

(54) **PRODUCTION METHOD FOR METAL WIRING AND KIT**

HERSTELLUNGSVERFAHREN FÜR METALLVERDRAHTUNG UND KIT

PROCÉDÉ DE PRODUCTION DE CÂBLAGE MÉTALLIQUE ET KIT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.09.2020 JP 2020149216**
**30.04.2021 JP 2021077539**

(43) Date of publication of application:
**12.07.2023 Bulletin 2023/28**

(73) Proprietor: **Asahi Kasei Kabushiki Kaisha**
**Tokyo 1000006 (JP)**

(72) Inventors:
- **KOGAWA, Masashi**
  **Tokyo 100-0006 (JP)**
- **YUMOTO, Toru**
  **Tokyo 100-0006 (JP)**

(74) Representative: **D Young & Co LLP**
**3 Noble Street**
**London EC2V 7BQ (GB)**

(56) References cited:
**WO-A1-2019/017363**
**JP-A- 2005 173 551**
**JP-A- 2011 017 042**
**JP-A- 2019 090 110**
**JP-A- 2020 105 339**
**JP-A- 2020 113 706**
**US-A1- 2015 245 479**
**US-B2- 10 015 887**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
B22F 2998/10, B22F 1/107, B22F 3/1021, B22F 3/105;
B22F 2999/00, B22F 3/105, B22F 9/10, B22F 1/10;
B22F 2999/00, B22F 5/12, C22C 1/0425, B22F 3/105;
B22F 2999/00, B22F 12/41, B22F 9/10, B22F 1/10

## Description

FIELD

The present invention relates to a method for manufacturing a metal wire and a kit for manufacturing a metal wire.

BACKGROUND

A circuit board has a structure in which a conductive wire is provided on a substrate. A method for manufacturing a circuit board is generally as follows. First, a photoresist is applied on a substrate to which a metal foil is attached. The photoresist is then exposed and developed to obtain negative features of a desired circuit pattern. Next, the portions of the metal foil not covered by the photoresist is removed by chemical etching to form a pattern. A high-performance conductive substrate can thereby be manufactured.

However, the method of the prior art has drawbacks such as having a large number of steps, being complex, and requiring a photoresist material.

Direct wire printing technique, in which a desired wire pattern is directly printed on a substrate with a dispersion (hereinafter, also referred to as "paste material") having dispersed therein particles selected from the group consisting of metal particles and metal oxide particles, have been receiving attention. This technique has a small number of steps, does not require the use of a photoresist material, and has very high productivity.

As an example of the direct wire printing technique, there is known a method in which a paste material is applied to the entire surface of a substrate to form a coating, and the coating is then irradiated with laser light in a pattern and selectively fired to obtain a desired pattern (refer to, for example, PTLs 1 and 2).

PTL 2 describes that when a GaAlAs laser having a wavelength of 830 nm was emitted for drawing, the beam diameter on a copper oxide thin film was 5 μm, the copper oxide on the laser light-irradiated portion was reduced due to local heating, and a reduced copper region having a diameter of approximately 5 μm was formed.

JP 2020 113706 A describes a structure with a conductive pattern, including: a substrate (a support body); a burning region (a conductive layer containing a reduction copper) arranged on a face structure by a substrate, containing a void and a carbon, and having a grain boundary; and a conductive pattern region arranged on the conductive layer, and structured by a plating copper layer.

US 10 015 887 B2 describes a method for manufacturing including coating a substrate with a matrix containing a material to be patterned on the substrate.

US 2015/245479 A1 describes a process for manufacturing a conductive film including: a step for applying a dispersion which contains metal oxide particles to a substrate to form a precursor film which contains the particles; and a step for irradiating the precursor film with a continuous-wave laser beam while scanning the laser beam relatively, and thereby reducing the metal oxide in an irradiated area to form a metal-containing conductive film.

WO 2019/022230 A1 describes a copper oxide ink containing a copper oxide, a dispersant, and a reducing agent. The content of the reducing agent is in the range of $0.00010 \leq$ (reducing agent mass/copper oxide mass) $\leq 0.10$, and the content of the dispersant is in the range of $0.0050 \leq$ (dispersant mass/copper oxide mass) $\leq 0.30$.

[CITATION LIST]

[PATENT LITERATURE]

[PTL 1] WO 2010/024385
[PTL 2] Japanese Unexamined Patent Publication (Kokai) No. 5-37126

SUMMARY

[TECHNICAL PROBLEM]

When a wire is formed by drawing with laser light irradiation as described above, the coating remains in the regions not irradiated with light. This remaining coating causes problems such as growth of the metal outside of the intended wire pattern and short-circuiting due to migration in the plating operation after wire formation. Therefore, it is necessary to sufficiently remove the remaining coating by a development operation after laser light irradiation.

The effect of removing the remaining coating is enhanced by applying a physical force, such as emitting ultrasonic waves in the developer during development. However, such a physical force damages the metal wire, leading to

problems such as breakage of the metal wire or increased resistance.

The present invention has been made in view of the above points. An object thereof is to provide a method for manufacturing a metal wire that is capable of sufficiently removing a coating remaining between metal wires in a development step, as well as a kit comprising a structure with a dried coating and a developer and a kit comprising a structure with a conductive portion and a developer.

[SOLUTION TO PROBLEM]

The solution to the above technical problem is given by the appended set of claims.

[ADVANTAGEOUS EFFECTS OF INVENTION]

According to one aspect of the present invention, a method for manufacturing a metal wire capable of sufficiently removing a coating remaining between metal wires in a development step, as well as a kit comprising a structure with a dried coating and a developer and a kit comprising a structure with a conductive portion and a developer, can be provided.

BRIEF DESCRIPTION OF DRAWINGS

FIG. 1 is an explanatory diagram showing one example of the method for manufacturing a metal wire according to the present embodiment.
FIG. 2 is a schematic diagram illustrating overlapping irradiation with laser light in the method for manufacturing a metal wire according to the present embodiment.
FIG. 3 is a schematic diagram showing one example of a jig for retaining a structure with a conductive portion in a development step of the method for manufacturing a metal wire according to the present embodiment.
FIG. 4 is a schematic diagram showing one example of a jig for retaining a structure with a conductive portion in a development step of the method for manufacturing a metal wire according to the present embodiment.
FIG. 5 is a schematic diagram showing one example of a jig for retaining a structure with a conductive portion in a development step of the method for manufacturing a metal wire according to the present embodiment.
FIG. 6 is an explanatory diagram showing an example in which a used developer is regenerated in the method for manufacturing a metal wire according to the present embodiment.
FIG. 7 is an explanatory diagram showing an example of a process flow when regenerating a used developer in the method for manufacturing a metal wire according to the present embodiment.
FIG. 8 is an explanatory diagram showing one example of a metal wire manufacturing system according to the present embodiment.

DESCRIPTION OF EMBODIMENTS

Hereinafter, an embodiment of the present invention (hereinafter, abbreviated as "the present embodiment") will be described in detail.

<Method for manufacturing metal wire>

In the present embodiment, the method for manufacturing a metal wire comprises:

an application step of applying a dispersion comprising metal particles and/or metal oxide particles on a surface of a base material to form a dispersion layer;
a drying step of drying the dispersion layer to form a structure with a dried coating, the structure having the base material and the dried coating disposed on the base material;
a laser light irradiation step of irradiating the dried coating with laser light to form a metal wire; and
a development step of developing and removing a region of the dried coating other than the metal wire by a developer, wherein
the development step comprises a first development process to develop and remove a region of the dried coating other than the metal wire by a first developer (referred to below as the "first aspect" of the invention), and wherein the development step further comprises a second development process of developing and removing a region of the dried coating other than the metal wire by a second developer after the first development process (referred to below as the "second aspect" of the invention).

The present inventors have noticed that when regions (hereinafter, also referred to as exposed portions) of the dried coating disposed on the base material irradiated with laser light are formed as metal wires and regions of the dried coating not irradiated with laser light (hereinafter, also referred to as unexposed portions) are developed and removed by a developer, the unexposed portions may not be sufficiently removed by the developer and the metal wire may be damaged or separated by development. The present inventors have examined various means of avoiding these problems, and as a result, have discovered that by controlling the composition of the developer, the unexposed portions can be satisfactorily removed by development.

In the first aspect, the development step comprises a first development process for developing and removing a region of the dried coating other than a metal wire by a developer. The first developer according to the first aspect comprises a solvent, which is an organic solvent, water, or a mixture thereof, and an additive (A). The organic solvent is one or more selected from the group consisting of alcohol solvents, ketone solvents, ester solvents, amine solvents, and ether solvents. The concentration of the additive (A) in the first developer according to the first aspect is 0.01% by mass or greater and 20% by mass or less.

The development step comprises a first development process using a first developer and a second development process using a second developer. The metal particles and/or the metal oxide particles have a higher solubility in the second developer than in the first developer. In one aspect, the first developer according to the second aspect comprises water and/or an alcohol solvent. In one aspect, the second developer according to the second aspect comprises an organic solvent.

[Composition of developer]

(First aspect)

In the first aspect, at least the first developer is used as the developer. The first developer comprises a solvent, which is an organic solvent, water, or a mixture thereof, and an additive (A). In one aspect, the first developer consists of these. The organic solvent contained in the first developer is one or more selected from the group consisting of alcohol solvents, ketone solvents, ester solvents, amine solvents, and ether solvents.

The solvent may be one type or a combination of two or more types, and preferably comprises a polar solvent, and is more preferably composed of a polar solvent. Polar solvents have excellent dispersibility of metal particles and/or metal oxide particles, and are thus advantageous from the viewpoint of developability. The solvent (may be one type or a combination of two or more types) contained in the developer preferably comprises the same compound as at least one dispersion medium (may be one type or a combination of two or more types) contained in the dispersion, or is composed of the same compound as the dispersion medium.

Alcohol solvents are alcoholic hydroxyl group-containing compounds. Examples of the alcohol solvent can include monohydric alcohols, dihydric alcohols, and trihydric alcohols, such as methanol, ethanol, n-propanol, i-propanol, n-butanol, i-butanol, sec-butanol, t-butanol, n-pentanol, i-pentanol, sec-pentanol, t-pentanol, 2-methylbutanol, 2-ethylbutanol, 3-methoxybutanol, n-hexanol, sec-hexanol, 2-methylpentanol, sec-heptanol, 3-heptanol, n-octanol, sec-octanol, 2-ethylhexanol, n-nonyl alcohol, 2,6-dimethyl-4-heptanol, n-decanol, cyclohexanol, methylcyclohexanol, 3,3,5-trimethylcyclohexanol, phenol, benzyl alcohol, diacetone alcohol, ethylene glycol, 1,2-propylene glycol, 1,3-butylene glycol, 2-pentanediol, 2-methylpentane-2,4-diol, 2,5-hexanediol, 2,4-heptanediol, 2-ethylhexane-1,3-diol, diethylene glycol, dipropylene glycol, hexanediol, octanediol, triethylene glycol, and tri-1,2-propylene glycol. The alcohol solvent may be an alcohol ester or an alcohol ether. For example:

alcohol ethers exemplified below as ether solvents, specifically glycol ethers such as ethylene glycol monomethyl ether, ethylene glycol monoethyl ether, ethylene glycol monobutyl ether, propylene glycol monomethyl ether, propylene glycol monoethyl ether, propylene glycol monopropyl ether, propylene glycol tertiary butyl ether, and dipropylene glycol monomethyl ether; and
glycol esters such as propylene glycol monomethyl ether acetate

are encompassed in alcohol solvents.

Examples of the ketone solvent include acetone, methyl ethyl ketone, methyl isobutyl ketone, diisobutyl ketone, and cyclohexanone.

Examples of the ester solvent include carboxylic acid esters, such as methyl acetate, ethyl acetate, butyl acetate, isobutyl acetate, methoxybutyl acetate, amyl acetate, n-propyl acetate, isopropyl acetate, methyl lactate, ethyl lactate, and butyl lactate. In one aspect, the ester may be an alkyl carboxylate, and the alkyl may be substituted or unsubstituted.

Amine solvents are amino group-containing compounds. Examples thereof can include primary amines, secondary amines, tertiary amines, alkanolamines, and amides. Examples of the amine solvent can include diethylenetriamine, 2-aminoethanol, diethanolamine, triethanolamine, monoisopropanolamine, diisopropanolamine, triisopropanolamine, N-methylethanolamine, N-methyldiethanolamine, dicyclohexylamine, n-methyl-2-pyrrolidone, and N,N-dimethylformamide.

Examples of the ether solvent include diethyl ether, diisopropyl ether, ethylene glycol monomethyl ether, ethylene glycol monoethyl ether, ethylene glycol monobutyl ether, 1,4-diethylene oxide, vinyl ethylene carbonate, and tetrahydrofuran.

In a preferred aspect, the solvent in the first developer comprises water and/or an alcohol solvent, or is water and/or an alcohol solvent. Water and alcohol solvents are solvents capable of satisfactorily dispersing the additive (A). By including the additive (A) in the first developer, the redispersibility and/or solubility of the particles on the base material can be improved, and the developability of the particles can be improved. Particularly, when the additive (A) comprises a dispersant or is a dispersant, the redispersibility of the particles on the base material improves, and the additive (A) is thus suitable for dispersing metal particles and/or metal oxide particles adhering to the base material into a developer. The solvent in the first developer preferably contains one or more selected from the group consisting of water, ethanol, n-propanol, i-propanol, butanol, heptanol, and octanol, in that polarity can be increased. The solvent is particularly preferably composed of one or more of the above.

In one aspect, the content ratio of water in the first developer may be 10% by mass or greater, 20% by mass or greater, or 30% by mass or greater, and in one aspect, may be 99.99% by mass or less, 99.9% by mass or less, 99% by mass or less, 98% by mass or less, or 97% by mass or less.

In one aspect, the content ratio of the alcohol solvent in the first developer may be 10% by mass or greater, 20% by mass or greater, or 30% by mass or greater, and in one aspect, may be 99.99% by mass or less, 99.9% by mass or less, 99% by mass or less, 98% by mass or less, or 97% by mass or less.

In one aspect, the total content ratio of water and the alcohol solvent in the first developer may be 20% by mass or greater, 40% by mass or greater, 50% by mass or greater, 60% by mass or greater, 70% by mass or greater, 80% by mass or greater, 85% by mass or greater, and 90% by mass or greater. In one aspect, the total content ratio may be less than 100% by mass, 99.99% by mass or less, 99.9% by mass or less, 99.5% by mass or less, 99% by mass or less, 98% by mass or less, or 97% by mass or less.

In one aspect, the content ratio of the solvent in the first developer may be 20% by mass or greater, 40% by mass or greater, 50% by mass or greater, 60% by mass or greater, 70% by mass or greater, 80% by mass or greater, 85% by mass or greater, or 90% by mass or greater. In one aspect, the total content ratio may be less than 100% by mass, 99.99% by mass or less, 99.9% by mass or less, 99.5% by mass or less, 99% by mass or less, 98% by mass or less, or 97% by mass or less.

In one aspect, the additive (A) is one or more selected from the group consisting of surfactants, dispersants, reductants, and complexing agents. In one aspect, the content ratio of the additive (A) in the first developer is 0.01% by mass or greater, 0.1% by mass or greater, 0.5% by mass or greater, or 1.0% by mass or greater, from the viewpoint of having a satisfactory effect of improving developability by improving redispersibility and/or solubility of the particles on the base material, and in one aspect, is 20% by mass or less, 15% by mass or less, or 10% by mass or less, from the viewpoints of suppressing dissolution of the metal wire by the additive (A), forming a low-viscosity developer suitable for development when using a high-viscosity additive (A), preventing adhesion of excess additive (A) to the base material and the metal wire, and simplifying a washing step after development.

In one aspect, the additive (A) comprises a surfactant or is a surfactant. The surfactant is not particularly limited. For example, an anionic surfactant, a nonionic surfactant, a cationic surfactant, an amphoteric surfactant, and a polymeric surfactant can be used.

Examples of the anionic surfactant include: fatty acid salts such as sodium lauryl sulfate; higher alcohol sulfate salts; alkylbenzenesulfonates such as sodium dodecylbenzenesulfonate; polyoxyethylene alkyl ether sulfate, polyoxyethylene polycyclic phenyl ether sulfate, polyoxynonylphenyl ether sulfate, polyoxyethylene-polyoxypropylene glycol ether sulfate; and so-called reactive surfactants having a sulfonic acid group or sulfate ester group and a polymerizable unsaturated double bond in the molecule.

Examples of the cationic surfactant include alkylamine salts and quaternary ammonium salts.

Examples of the amphoteric surfactant include cocamidopropyl betaine, cocamidopropyl hydroxysultaine, lauryldimethylaminoacetic acid betaine, stearyldimethylaminoacetic acid betaine, dodecylaminomethyldimethylsulfopropylbetaine, octadecylaminomethyldimethylsulfopropylbetaine, 2-alkyl-N-carboxymethyl-N-hydroxyethylimidazolinium betaine, alkyldiaminoethylglycine hydrochloride, alkylpolyaminoethylglycine, sodium lauroyl glutamate, potassium lauroyl glutamate, N-alkylaminopropylglycine, and alkyldimethylamine oxide.

Examples of the nonionic surfactant include polyoxyethylene alkyl ether, polyoxyethylene nonylphenyl ether, sorbitan fatty acid ester, polyoxyethylene fatty acid ester, polyoxyethylene-polyoxypropylene block copolymer, or reactive nonionic surfactants having these frameworks and polymerizable unsaturated double bonds in the molecule.

Examples of the polymeric surfactant include optionally denatured polyvinyl alcohol.

The content ratio of the surfactant in the first developer is preferably 0.01% by mass or greater, 0.1% by mass or greater, 0.5% by mass or greater, or 1.0% by mass or greater, from the viewpoint of improving the redispersibility and/or

solubility of the particles on the base material, and is preferably 20% by mass or less, 15% by mass or less, or 10% by mass or less, from the viewpoints of preventing adhesion of excess surfactant to the base material and the metal wire and simplifying the washing step after development.

In one aspect, the additive (A) comprises or is a dispersant. Since the dispersant can satisfactorily disperse the coating components of the dried coating (particularly metal particles and/or metal oxide particles, which are components difficult to remove by development) in the developer, satisfactory development in solvent systems, such as water and/or an organic solvent selected from the group consisting of alcohol solvents, ketone solvents, ester solvents, amine solvents, and ether solvents, which do not easily damage the metal wire and the base material, can be realized. Specifically, a developer comprising a dispersant contributes to both avoidance of damage to the metal wire and good developability.

The dispersant can efficiently disperse (i.e., efficiently remove) in the developer the metal particles and/or metal oxide particles adhering to the base material. Dispersants described below in the section [Compositions of dispersion and dried coating] are preferable as dispersants that can be contained in the dispersion of the present disclosure. For example, when a phosphorus-containing organic compound is used, the metal particles and/or the metal oxide particles (particularly copper oxide particles) are satisfactorily dispersed in the developer, which facilitates development. Accordingly, in one aspect, examples of suitable compounds for the dispersant in the developer are the same as examples of suitable compounds described below in the section [Composition of dispersion and dried coating].

The number average molecular weight of the dispersant is not particularly limited, but is preferably 300 to 300,000, more preferably 300 to 30,000, and even more preferably 300 to 10,000. When the number average molecular weight is 300 or greater, the dispersion stability of the developer tends to increase. When the number average molecular weight is 300,000 or less, particularly 30,000 or less, the amount of dispersant remaining after development is smaller, and resistance in the metal wire can be decreased. As described herein, the number average molecular weight is a value determined by standard polystyrene conversion using gel permeation chromatography.

The additive (A) comprises a phosphorus-containing organic compound. The additive (A), particularly the dispersant, is preferably a phosphorus-containing organic compound from the viewpoint of excellent dispersibility of the metal particles and/or metal oxide particles. In addition, the additive (A), particularly the dispersant, preferably adsorbs to the metal particles and/or metal oxide particles, and has a group (for example, a hydroxyl group) having an affinity to these particles, from the viewpoint of suppressing aggregation of particles due to steric hindrance effect. Particularly, the combined use of metal oxide particles and a hydroxyl-containing dispersant is preferable. A particularly suitable example of the additive (A), particularly the dispersant, is a phosphorus-containing organic compound having a phosphoric acid group.

It is preferable that the phosphorus-containing organic compound be easily decomposed or evaporated by light and/or heat. By using an organic substance that is easily decomposed or evaporated by light and/or heat, residue of the organic substance is less likely to remain after firing, and a metal wire having low resistivity can be obtained.

The decomposition temperature of the phosphorus-containing organic compound is not particularly limited, but is preferably 600 °C or lower, more preferably 400 °C or lower, and even more preferably 200 °C or lower. The decomposition temperature may preferably be 60 °C or higher, 90 °C or higher, or 120 °C or higher from the viewpoint of the stability of the phosphorus-containing organic compound. As described herein, the decomposition temperature is a value of decomposition start temperature determined by thermogravimetric differential thermal analysis.

The boiling point of the phosphorus-containing organic compound at normal pressure is not limited, but is preferably 300 °C or lower, more preferably 200 °C or lower, and even more preferably 150 °C or lower. The boiling point is preferably 60 °C or higher, 90 °C or higher, or 120 °C or higher from the viewpoint of stability of the phosphorus-containing organic compound.

The adsorption properties of the phosphorus-containing organic compound are not limited, but it is preferable that the compound can absorb the laser light used for firing. As described herein, the ability to absorb the laser light used for firing means that the absorption coefficient at a wavelength of 532 nm measured with an ultraviolet-visible spectrophotometer is 0.10 $cm^{-1}$ or more. More specifically, it is preferable that the phosphorus-containing organic compound absorb light at, for example, 355 nm, 405 nm, 445 nm, 450 nm, 532 nm, or 1064 nm (i.e., a wavelength at which the absorption coefficient is 0.10 $cm^{-1}$ or more) as the emission wavelength (center wavelength) of the laser light used for firing. Particularly, when the base material is a resin base material, a phosphorus-containing organic compound that absorbs light having a center wavelength of 355 nm, 405 nm, 445 nm, and/or 450 nm is preferable.

It is preferable that the phosphorus-containing organic compound be a phosphate ester from the viewpoint of improving atmospheric stability of the developer. For example, a phosphate monoester represented by the following general formula (1):

[Chem. 1]

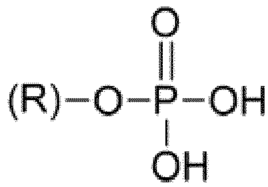

(1)

wherein R is a monovalent organic group, is preferable in that the phosphate ester has excellent adsorption to metal oxide particles and exhibits moderate adhesive property to the base material, which contributes to both stable formation of the metal wire and satisfactory development of unexposed portions. Examples of the R include substituted and unsubstituted hydrocarbon groups.

As one example of the phosphate monoester, a compound having a structure represented by the following formula (2):

[Chem. 2]

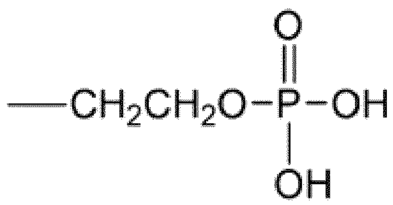

(2)

can be exemplified.

As one example of the phosphate monoester, a compound having a structure represented by the following formula (3):

[Chem. 3]

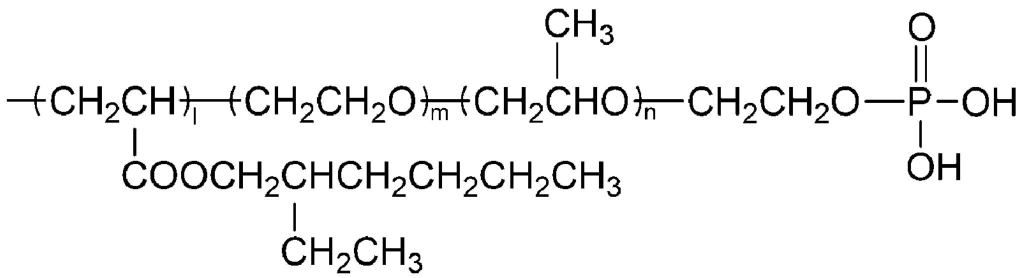

(3)

wherein l, m, and n are each independently integers of 1 to 20, can be exemplified.

In the above formula (3), l is an integer of 1 to 20, preferably an integer of 1 to 15, and more preferably an integer of 1 to 10; m is an integer of 1 to 20, preferably an integer of 1 to 15, and more preferably an integer of 1 to 10; and n is an integer of 1 to 20, preferably an integer of 1 to 15, and more preferably an integer of 1 to 10.

The organic structures constituting the phosphorus-containing organic compound may have a structure derived (specifically, through functional group denaturation, functional group modification, or polymerization) from compounds such as polyethylene glycol (PEG), polypropylene glycol (PPG), polyimide, polyesters (for example, polyethylene terephthalate (PET) and polyethylene naphthalate (PEN)), polyether sulfone (PES), polycarbonate (PC), polyvinyl alcohol (PVA), polyvinyl butyral (PVB), polyacetal, polyarylate (PAR), polyamide (PA), polyamideimide (PAI), polyetherimide (PEI), polyphenylene ether (PPE), polyphenylene sulfide (PPS), polyether ketone (PEK), polyphthalamide (PPA), polyethernitrile (PENt), polybenzimidazole (PBI), polycarbodiimide, polysiloxanes, polymethacrylamide, nitrile rubber, acrylic rubber, polyethylene tetrafluoride, epoxy resins, phenolic resins, melamine resins, urea resins, polymethyl methacrylate resin (PMMA), polybutene, polypentene, ethylene-propylene copolymers, ethylene-butene-diene copolymers, polybutadiene, polyisoprene, ethylene-propylene-diene copolymers, butyl rubber, polymethylpentene (PMP), polystyrene (PS), styrene-butadiene copolymers, polyethylene (PE), polyvinyl chloride (PVC), polyvinylidene fluoride (PVDF), polyether ether ketone (PEEK), phenolic novolacs, benzocyclobutene, polyvinylphenol, polychloroprene,

polyoxymethylene, polysulfone (PSF), polysulfides, silicone resins, aldose, cellulose, amylose, pullulan, dextrin, glucan, fructan, and chitin. A phosphorus-containing organic compound having a polymer framework selected from polyethylene glycol, polypropylene glycol, polyacetal, polybutene, and polysulfide is easily decomposed and does not easily leave residue in the metal wire obtained after firing, and is thus preferable.

Commercially available materials can be used as specific examples of the phosphorus-containing organic compound. Specific examples thereof can include DISPERBYK™-102, DISPERBYK-103, DISPERBYK-106, DISPERBYK-109, DISPERBYK-110, DISPERBYK-111, DISPERBYK-118, DISPERBYK-140, DISPERBYK-145, DISPERBYK-168, DISPERBYK-180, DISPERBYK-182, DISPERBYK-187, DISPERBYK-190, DISPERBYK-191, DISPERBYK-193, DISPERBYK-194N, DISPERBYK-199, DISPERBYK-2000, DISPERBYK-2001, DISPERBYK-2008, DISPERBYK-2009, DISPERBYK-2010, DISPERBYK-2012, DISPERBYK-2013, DISPERBYK-2015, DISPERBYK-2022, DISPERBYK-2025, DISPERBYK-2050, DISPERBYK-2152, DISPERBYK-2055, DISPERBYK-2060, DISPERBYK-2061, DISPERBYK-2164, DISPERBYK-2096, DISPERBYK-2200, BYK™-405, BYK-607, BYK-9076, BYK-9077, and BYK-P105 manufactured by BYK-Chemie; and PLYSURF™ M208F and PLYSURF DBS manufactured by DKS Co., Ltd. These may be used singly, or a plurality thereof may be mixed and used.

Particularly, it is preferable that the dispersant in the first developer be a phosphorus-containing organic compound. It is more preferable that the phosphorus-containing organic compound be the same as the phosphorus-containing organic substance in the dispersion. Being the same substance results in more satisfactory redispersion of the particles on the base material.

The content ratio of the dispersant in the first developer is preferably 0.01% by mass or greater, 0.1% by mass or greater, 0.5% by mass or greater, or 1.0% by mass or greater such that the metal particles and/or metal oxide particles adhering to the base material can be efficiently dispersed in the developer (i.e., efficiently removed), and is preferably 20% by mass or less, 15% by mass or less, or 10% by mass or less such that dissolution of the metal wire due to the dispersant can be suppressed, a low-viscosity developer suitable for development can be formed even when a high-viscosity dispersant is used, adhesion of excess dispersant to the base material and the metal wire can be prevented, and the washing step after development can be simplified.

In one aspect, the additive (A) comprises a reductant or is a reductant. The reductant preferably comprises hydrazine and/or hydrazine hydrate, and more preferably is a hydrazine and/or hydrazine hydrate. It is advantageous for the first developer to comprise a reductant in that the metal particles and/or metal oxide particles adhering to the base material can be efficiently dispersed and/or dissolved (i.e., efficiently removed) in the developer.

The content ratio of the reductant in the first developer is preferably 0.01% by mass or greater, 0.1% by mass or greater, 0.5% by mass or greater, or 1.0% by mass or greater, from the viewpoint of improving redispersibility and/or solubility of the particles on the base material, and is preferably 20% by mass or less, 15% by mass or less, or 10% by mass or less, from the viewpoints of preventing adhesion of excess reductant to the base material and the metal wire and simplifying the washing step after development.

In one aspect, the additive (A) comprises a complexing agent or is a complexing agent. Examples of the complexing agent include: carboxylic acids such as citric acid, hydroxyacetic acid, tartaric acid, malic acid, lactic acid, and gluconic acid; amino acids such as glycine; ketones such as acetylacetone; amines such as ethylenediamine and diethylenetriamine; nitrogen-containing heterocyclic compounds such as pyridine, 2,2'-bipyridine and 1,10-phenanthroline; and aminopolycarboxylic acids such as nitrilotriacetic acid and ethylenediaminetetraacetic acid. It is advantageous for the first developer to comprise a complexing agent in that the metal particles and/or metal oxide particles adhering to the base material can be efficiently dissolved (i.e., efficiently removed) in the developer.

The content ratio of the complexing agent in the first developer is preferably 0.01% by mass or greater, 0.1% by mass or greater, 0.5% by mass or greater, or 1.0% by mass or greater, from the viewpoint of improving redispersibility and/or solubility of the particles on the base material, and is preferably 20% by mass or less, 15% by mass or less, or 10% by mass or less, from the viewpoint of reducing damage to the metal wire.

The main component (i.e., the component contained in the largest amount based on mass in each additive) of the additive (A) contained in the first developer is preferably the same as that of the additive (B). When the main components of the additive (A) and the additive (B) are the same, the redispersion of the particles on the base material improves. Particularly, it is even more preferable that the additive (A) and the additive (B) be phosphorus-containing organic compounds from the viewpoint of excellent dispersibility of the metal particles and/or metal oxide particles.

In the first aspect, a second developer may be used in addition to the first developer. An additional developer may be used in addition to the first and second developers. The first developer, the second developer, and the additional developer may have the same composition as each other, but preferably have different compositions. In one aspect, the developer is a combination of the first developer comprising a solvent, which is an organic solvent, water, or a mixture thereof, and the additive (A) and a second developer comprising an organic solvent. The organic solvent can dissolve and remove metals or metal oxides, and can thus prevent metal from remaining between wires and are particularly suitable for finishing development. From such a viewpoint, it is advantageous to use the developer according to the above combination in an aspect in which a first development process using the first developer and then a second development process using

the second developer were carried out. Specific examples of the second developer and the organic solvent that can be contained therein can be the same as those of the second aspect described below. The additional developer is preferably a developer comprising the same organic solvent as that used in the second developer and having a higher copper oxide solubility than the second developer, or the additional developer can be the same developer as the second developer according to the second aspect.

In the first aspect, at least a first developer and a second developer are used as the developer. In one aspect, the first developer according to the second aspect comprises water and/or an alcohol solvent. In one aspect, the first developer according to the second aspect comprises or consists of water and/or an alcohol solvent and an additive (A). Specific examples of the types and amounts of the alcohol solvent and the additive (A) can be the same as those exemplified for the first developer according to the first aspect.

In one aspect, the second developer according to the second aspect may have the same composition as the first developer according to the first aspect.

In one aspect, the second developer according to the second aspect comprises an organic solvent. The organic solvent can dissolve and remove metals or metal oxides, and can thus prevent metal from remaining between wires and are particularly suitable for finishing development. As the organic solvent, amine solvents, alcohol solvents, hydrocarbon solvents, ester solvents, and ketone solvents are suitable. One or more thereof may be used. Amine solvents are particularly preferable as the organic solvent.

Examples of the amine solvent can include amines (primary amines, secondary amines, and tertiary amines), alkanolamines, and amides. Specific examples thereof can include diethylenetriamine, 2-aminoethanol, diethanolamine, triethanolamine, monoisopropanolamine, diisopropanolamine, triisopropanolamine, N-methylethanolamine, N-methyldiethanolamine, dicyclohexylamine, n-methyl-2-pyrrolidone, and N,N-dimethylformamide.

Examples of the alcohol solvent can include monohydric and polyhydric alcohols and ethers and esters of the alcohols. The alcohol is preferably a glycol. More specific examples of the alcohol include:

monohydric alcohols such as methanol, ethanol, n-propanol, i-propanol, n-butanol, i-butanol, sec-butanol, t-butanol, n-pentanol, i-pentanol, sec-pentanol, t-pentanol, 2- methylbutanol, 2-ethylbutanol, 3-methoxybutanol, n-hexanol, sec-hexanol, 2-methylpentanol, sec-heptanol, 3-heptanol, n-octanol, sec-octanol, 2-ethylhexanol, n-nonyl alcohol, 2,6-dimethyl-4-heptanol, n-decanol, cyclohexanol, methylcyclohexanol, 3,3,5-trimethylcyclohexanol, phenol, benzyl alcohol, and diacetone alcohol;
glycols such as ethylene glycol, 1,2-propylene glycol, 1,3-butylene glycol, 2-pentanediol, 2-methylpentane-2,4-diol, 2,5-hexanediol, 2,4-heptanediol, 2-ethylhexane-1,3-diol, diethylene glycol, dipropylene glycol, hexanediol, octanediol, triethylene glycol, and tri-1,2-propylene glycol;
glycol ethers such as ethylene glycol monomethyl ether, ethylene glycol monoethyl ether, ethylene glycol monobutyl ether, propylene glycol monomethyl ether, propylene glycol monoethyl ether, propylene glycol monopropyl ether, propylene glycol tertiary butyl ether, and dipropylene glycol monomethyl ether; and
glycol esters such as propylene glycol monomethyl ether acetate.

Examples of the hydrocarbon solvent include pentane, hexane, octane, nonane, decane, cyclohexane, methylcyclohexane, toluene, xylene, mesitylene, and ethylbenzene.

Examples of the ester solvent include 3-methoxy-3-methyl-butyl acetate, ethoxyethyl propionate, ethyl glycerol acetate, normal propyl acetate, and isopropyl acetate.

Examples of the ketone solvent include methyl ethyl ketone, methyl isobutyl ketone, and dimethyl carbonate.

Amine solvents are particularly preferable as the organic solvent from the viewpoint of developability. Specifically, diethylenetriamine, 2-aminoethanol, diethanolamine, triethanolamine, monoisopropanolamine, diisopropanolamine, triisopropanolamine, N-methyl ethanolamine, N-methyldiethanolamine, dicyclohexylamine, n-methyl-2-pyrrolidone, and N,N-dimethylformamide are suitable. It is particularly preferable to use at least one of diethylenetriamine and 2-aminoethanol from the viewpoint of developability.

In one aspect, the organic solvent can also function as the additive (A) and/or the additive (B) of the present disclosure. For example, diethylenetriamine can function both as an organic solvent and a complexing agent. The amount of such a component present in the developer is calculated into both the organic solvent content ratio and the additive content ratio.

In one aspect, the content ratio of the organic solvent in the second developer may be 1% by mass or greater, 2% by mass or greater, or 3% by mass or greater. In one aspect, the above content ratio may be 100% by mass, or in one aspect, may be 98% by mass or less, 97% by mass or less, or 95% by mass or less. In this case, the balance may comprise water and/or the additive (A) (for example, a dispersant) of the present disclosure. In one aspect, the second developer can be free of the additive (A). In one aspect, the second developer is an organic solvent or a mixture of an organic solvent and water.

In one aspect, the content ratio of water in the second developer may be 1% by mass or greater, 2% by mass or

greater, or 3% by mass or greater, and may be 100% by mass, 99% by mass or less, 98% by mass or less, or 95% by mass or less.

The additive (A) in the first developer is preferably a dispersant, particularly a phosphorus-containing organic compound, from the viewpoint of having excellent redispersibility of the metal particles and/or metal oxide particles. It is particularly preferable that the first developer and the dispersion contain the same phosphorus-containing organic compound from the viewpoint of improving redispersibility of the particles on the base material. By improving dispersibility of the particles in the first developer, the effect of developability in the second developer is improved.

The main component (i.e., the component contained in the largest amount based on mass in the additive) of the additive (A) contained in the first developer is preferably the same as that of the additive (B) contained in the dispersion. When the main components of the additive (A) and the additive (B) are the same, the redispersibility of the particles on the base material improves. Particularly, it is even more preferable that the additive (A) and the additive (B) be phosphorus-containing organic compounds from the viewpoint of satisfactory dispersibility of the metal particles and/or metal oxide particles.

(Solubility)

In the first aspects, the metal particles and/or metal oxide particles have a higher solubility in the second developer than in the first developer. Note that the above solubility is a value measured by inductively coupled plasma (ICP) emission spectrometry. Specifically, solubility measurement is as follows.

0.10 g of a powder of metal particles and/or metal oxide particles is added to 40 ml of a developer and allowed to stand at room temperature of 25 °C for 6 h. The developer comprising the powder is then filtered through a 0.2-μm filter and diluted 100-fold with 0.10 mol/L nitric acid. A metal concentration (unit: mg/L) of the resulting diluted solution is measured using an ICP light-emitting apparatus (for example, manufactured SII Nanotechnology Co., Ltd.). From the metal concentration, the concentration (unit: mg/L) of metal particles and/or metal oxide particles is calculated and used as the solubility of the metal particles and/or metal oxide particles.

According to the solubility as described above, a satisfactory development and removal efficiency for the metal particles and/or metal oxide particles adhering to the base material is obtained by carrying out development with the first developer and then with the second developer.

It is particularly preferable that the metal particles and/or metal oxide particles have a higher solubility in the second developer than in the first developer; the first developer comprise water and/or an alcohol solvent and an additive (A), wherein the additive (A) is a dispersant, particularly a phosphorus-containing compound; the dispersion comprise an additive (B); the main components (i.e., the component contained in the largest amount based on mass in the additive) of the additive (A) and the additive (B) are the same; and development with the first developer be carried out followed by development with the second developer. In this case, the development and removal efficiency of the metal particles and/or metal oxide particles adhering to the base material is particularly satisfactory.

In one aspect, copper oxide preferably has a high solubility in the second developer than in the first developer. Such a developer is particularly advantageous in improving development and removal efficiency when the metal oxide particles comprises copper oxide.

The solubility of metal particles and/or metal oxide particles or the solubility of copper oxide in the first developer is preferably 0.1 mg/L or more, 1.0 mg/L or more, 10 mg/L or more, or 100 mg/L or more, and is preferably 10000 mg/L or less, 5000 mg/L or less, 1000 mg/L or less, or 500 mg/L or less. Particularly, when the metal particles and/or metal oxide particles comprise copper oxide particles, the solubility of the copper oxide particles in the first developer is 0.1 mg/L or more, resulting in a high solubility of copper oxide particles and high developing effect. When the solubility is 5000 mg/L or less, damage to the metal wire can be reduced.

The solubility of metal particles and/or metal oxide particles or the solubility of copper oxide in the second developer is preferably 0.1 mg/L or more, 1.0 mg/L or more, 10 mg/L or more, or 100 mg/L or more, and is preferably 10000 mg/L or less, 5000 mg/L or less, or 1000 mg/L or less.

(Surface free energy)

The surface free energy of each of the first developer, the second developer, and the additional developer is preferably 10 mN/m or more, 15 mN/m or more, or 20 mN/m or more, and is preferably 75 mN/m or less, 60 mN/m or less, or 50 mN/m or less. As described herein, the surface free energy is a value measured by the pendant drop method using a contact angle meter.

The difference between the surface free energy of each of the first developer, the second developer, and the additional developer and the surface free energy of the dispersion is preferably 50 mN/m or less, 25 mN/m or less, or 10 mN/m or less, from the viewpoint of improving affinity between the developer and the dried coating to enhance the development and removal effect. The above difference is most preferably 0 mN/m, and may be, for example, 1 mN/m or

more or 5 mN/m or more from the viewpoint of ease of manufacture of the developer and the dispersion.

[Compositions of dispersion and dried coating]

In one aspect, the dried coating comprising metal particles and/or metal oxide particles of the present disclosure is formed by applying on the base material a dispersion comprising the metal particles and/or metal oxide particles and a dispersion medium, and optionally an additive (B) (in one aspect, a dispersant or a reductant), followed by drying. Therefore, in one aspect, the mass ratio of the components other than the dispersion medium in the dried coating may be considered the same as the mass ratio of the components other than the dispersion medium in the dispersion, or the content of metal element in the dried coating can be verified by SEM (scanning electron microscope) and EDX (energy dispersive X-ray analysis) apparatuses.

The content of the additive (B) (in one aspect, a dispersant) in the dispersion and in the dried coating can be verified using a TG-DTA (thermogravimetric differential thermal analysis) apparatus.

The content of the reductant in the dispersion can be verified by a surrogate method using a GC/MS (gas chromatograph/mass spectrometer) apparatus. In addition, the content of the reductant in the dried coating can be verified by a surrogate method using a GC/MS apparatus after redispersing the dried coating in a dispersion medium.

A measurement example using hydrazine as the reductant is indicated below.

(Hydrazine quantification method)

33 $\mu$g of hydrazine, 33 $\mu$g of a surrogate substance (hydrazine$^{15}N_2H_4$), and 1 ml solution of 1% benzaldehyde in acetonitrile are added to 50 $\mu$L of the dispersion. Finally, 20 $\mu$L of phosphoric acid is added therein, and GC/MS measurement is carried out 4 h later.

Similarly, 66 $\mu$g of hydrazine, 33 $\mu$g of a surrogate substance (hydrazine$^{15}N_2H_4$), and 1 ml solution of 1% benzaldehyde in acetonitrile are added to 50 $\mu$L of the dispersion. Finally, 20 $\mu$L of phosphoric acid is added therein, and GC/MS measurement is carried out 4 h later.

Similarly, 133 $\mu$g of hydrazine, 33 $\mu$g of a surrogate substance (hydrazin$^{15}N_2H_4$), and 1 ml solution of 1% benzaldehyde in acetonitrile are added to 50 $\mu$L of the dispersion. Finally, 20 $\mu$L of phosphoric acid is added therein, and GC/MS measurement is carried out 4 h later.

Finally, 33 $\mu$g of a surrogate substance (hydrazine$^{15}N_2H_4$) and 1 ml solution of 1% benzaldehyde in acetonitrile are added to 50 $\mu$L of the dispersion without adding hydrazine. Finally, 20 $\mu$L of phosphoric acid is added therein, and GC/MS measurement is carried out 4 h later.

A peak area value of hydrazine is obtained from the chromatogram at m/z = 207 from the above 4-point GC/MS measurement. A peak area value of the surrogate is then obtained from the mass chromatogram at m/z = 209. The x-axis represents the weight of hydrazine added/the weight of the surrogate substance added and the y-axis represents the peak area value of hydrazine/the peak area value of the surrogate substance to obtain a calibration curve according to the surrogate method.

The Y-intercept value obtained from the calibration curve is divided by the weight of hydrazine added/the weight of the surrogate substance added to obtain the weight of hydrazine.

((i) Metal particles and/or metal oxide particles)

The metal included in the metal particles and/or metal oxide particles is aluminum, vanadium, chromium, manganese, iron, cobalt, nickel, copper, zinc, gallium, germanium, ruthenium, rhodium, palladium, silver, indium, tin, antimony, iridium, platinum, gold, thallium, lead, or bismuth, and may be one thereof, an alloy comprising two or more thereof, or a mixture comprising two or more thereof. Examples of the metal oxide include oxides of metals recited above. Of these oxides, metal oxide particles of silver or copper are easily reduced when irradiated with laser light and can be formed into a uniform metal wire, and are thus preferable. Particularly, copper metal oxide particles have relatively high stability in the air and are available at low cost, which is advantageous from a business viewpoint, and are thus preferable. Copper oxides include, for example, cuprous oxide and cupric oxide. Cuprous oxide has a high absorbance to laser light, can be sintered at a low temperature, and can form a low-resistance sintered product, and is thus particularly preferable. Cuprous oxide and cupric oxide may be used singly or may be mixed and used.

In one aspect, the metal oxide particles comprise copper oxide particles or are copper oxide particles. The copper oxide particles may have a core/shell structure. Either the core or the shell may comprise cuprous oxide and/or cupric oxide.

The average secondary particle size of the copper oxide particles is not particularly limited, but is preferably 500 nm or less, 200 nm or less, 100 nm or less, 80 nm or less, 50 nm or less, or 20 nm or less. The average secondary particle size of the particles is preferably 1 nm or more, 5 nm or more, 10 nm or more, or 15 nm or more.

The average secondary particle size is the average particle size of aggregates (secondary particles) formed by aggregating a plurality of primary particles. It is preferable that the average secondary particle size be 500 nm or less in that fine metal wires tend to be easily formed on a support. It is preferable that the average secondary particle size be 1 nm or more, particularly 5 nm or more, in that long-term storage stability of the dispersion is improved. The average secondary particle size of the particles is a value measured by a dynamic scattering method.

The average primary particle size of the primary particles constituting the secondary particles is preferably 100 nm or less, more preferably 50 nm or less, and even more preferably 20 nm or less. The average primary particle size is preferably 1 nm or more, more preferably 2 nm or more, and even more preferably 5 nm or more.

When the average primary particle size is 100 nm or less, the firing temperature, which will be described below, can likely be lowered. Such low-temperature firing is considered possible because the smaller the particle size of the particles, the higher the surface energy and the lower the melting point.

It is preferable that the average primary particle size be 1 nm or more in that good dispersibility can be obtained. When a wire pattern is formed on a base material, the average primary particle size is preferably 2 nm or more or 5 nm or more, and preferably 100 nm or less or 50 nm or less, from the viewpoints of adhesive property to the base and low resistance. This tendency is remarkable when the base is resin. The average primary particle size of the particles is measured from an image observed with a transmission electron microscope. The diameter ((long diameter + short diameter)/2) of a single particle is measured from the above image, and the average value of 10 particles is obtained as the primary particle size.

The dispersion and the dried coating may comprise copper particles. Specifically, the dispersion and the dried coating of the present disclosure may comprise copper.

The dispersion and the dried coating may comprise copper oxide particles and copper particles. In this case, the mass ratio of copper particles to copper oxide particles (hereinafter, referred to as "copper particles/copper oxide particles") is preferably 1.0 or greater, 1.5 or greater, or 2.0 or greater, and is preferably 7.0 or less, 6.0 or less, or 5.0 or less, from the viewpoints of conductivity and crack prevention.

The content ratio of the metal particles and/or metal oxide particles in the dispersion, as the total content ratio of the metal particles and metal oxide particles, is preferably 0.50% by mass or greater, 1.0% by mass or greater, or 5.0% by mass or greater, and is preferably 60% by mass or less or 50% by mass or less to 100% by mass of the dispersion. When the above total content ratio is 60% by mass or less, aggregation of the metal particles and/or metal oxide particles tends to be suppressed. When the above total content ratio is 0.50% by mass or greater, the metal wire (i.e., the conductive film) obtained by firing the dried coating by laser light irradiation does not become excessively thin, and conductivity tends to be satisfactory.

The content ratio of metal particles and/or metal oxide particles in the dried coating, as the total content ratio of the metal particles and metal oxide particles, is preferably 40% by mass or greater, more preferably 55% by mass or greater, and even more preferably 70% by mass or greater to 100% by mass of the dried coating. The content ratio is preferably 98% by mass or less, more preferably 95% by mass or less, and even more preferably 90% by mass or less.

The content ratio of metal particles and/or metal oxide particles in the dried coating, as the total content ratio of the metal particles and metal oxide particles, is preferably 10% by volume or greater, more preferably 15% by volume or greater, and even more preferably 25% by volume or greater to 100% by volume of the dried coating. The content ratio is preferably 90% by volume or less, more preferably 76% by volume or less, and even more preferably 60% by volume or less.

It is preferable that the content ratio of the metal particles and/or metal oxide particles in the dried coating be 40% by mass or greater or 10% by volume or greater, in that the particles are fused to each other due to firing and exhibit satisfactory conductivity. A higher concentration of metal particles and/or metal oxide particles is preferable from the viewpoint of conductivity. When the content ratio is 98% by mass or less or 90% by volume or less, the dried coating can satisfactorily adhere to the base material such that metal wire can be stably formed. Particularly, when the content ratio is 95% by mass or less or 76% by volume or less, the adhesion to the base material is preferably stronger. When the content ratio is 90% by mass or less or 60% by volume or less, the dried coating has high flexibility, cracks do not easily form during bending, and reliability is enhanced.

((ii) Additive (B))

In one aspect, the dispersion and the dried coating comprise an additive (B). Examples of the additive (B) include surfactants, dispersants, reductants, and complexing agents. A dispersant contributes to satisfactory dispersion of metal particles and/or metal oxide particles.

Suitable examples of the surfactant as the additive (B) are the same as those exemplified for the additive (A). The content ratio of the surfactant in the dispersion is preferably 0.1% mass or greater, 0.2% by mass or greater, 0.5% by mass or greater, or 1.0% by mass or greater from the viewpoint of satisfactory dispersion of metal particles and/or metal oxide particles, and is preferably 20% by mass or less, 15% by mass or less, 10% by mass or less, or 8.0% by mass or less from

the viewpoint of satisfactory conductivity without increasing residue from the surfactant in the conductive film obtained by firing.

The number average molecular weight of the dispersant as the additive (B) is not particularly limited, but is preferably 300 to 300,000, more preferably 300 to 30,000, and even more preferably 300 to 10,000. When the number average molecular weight is 300 or greater, the dispersion stability of the dispersion tends to increase. When the number average molecular weight is 300,000 or less, firing is easy at the time of wire formation. When the number average molecular weight is 30,000 or less, the residual amount of the dispersant after firing decreases and resistance of the metal wire can be decreased.

As the additive (B), particularly the dispersant, a phosphorus-containing organic compound is preferable from the viewpoint of excellent dispersibility of the metal particles and/or metal oxide particles. In addition, the additive (B), particularly the dispersant, preferably adsorbs to the metal particles and/or metal oxide particles, and has a group (for example, a hydroxyl group) having an affinity to these particles, from the viewpoint of suppressing aggregation of particles due to steric hindrance effect. Particularly, the combined use of metal oxide particles and a hydroxyl-containing dispersant is preferable. The additive (B), particularly the dispersant, preferably comprises a phosphorus-containing organic compound. A particularly suitable example of the additive (B), particularly the dispersant, is a phosphorus-containing organic compound having a phosphoric acid group.

It is preferable that the phosphorus-containing organic compound be easily decomposed or evaporated by light and/or heat. By using an organic substance that is easily decomposed or evaporated by light and/or heat, residue of the organic substance is less likely to remain after firing, and a metal wire having low resistivity can be obtained.

The decomposition temperature of the phosphorus-containing organic compound is not particularly limited, but is preferably 600 °C or lower, more preferably 400 °C or lower, and even more preferably 200 °C or lower. The decomposition temperature may preferably be 60 °C or higher, 90 °C or higher, or 120 °C or higher from the viewpoint of the stability of the phosphorus-containing organic compound.

The boiling point of the phosphorus-containing organic compound at normal pressure is not limited, but is preferably 300 °C or lower, more preferably 200 °C or lower, and even more preferably 150 °C or lower. The boiling point is preferably 60 °C or higher, 90 °C or higher, or 120 °C or higher from the viewpoint of stability of the phosphorus-containing organic compound.

The adsorption properties of the phosphorus-containing organic compound are not limited, but it is preferable that the compound can absorb the laser light used for firing. As described herein, the ability to absorb the laser light used for firing means that the absorption coefficient at a wavelength of 532 nm measured with an ultraviolet-visible spectrophotometer is 0.10 $cm^{-1}$ or more. More specifically, it is preferable that the phosphorus-containing organic compound absorb light at, for example, 355 nm, 405 nm, 445 nm, 450 nm, 532 nm, or 1064 nm (i.e., a wavelength at which the absorption coefficient is 0.10 $cm^{-1}$ or more) as the emission wavelength (center wavelength) of the laser light used for firing. Particularly, when the base material is a resin base material, a phosphorus-containing organic compound that absorbs light having a center wavelength of 355 nm, 405 nm, 445 nm, and/or 450 nm is preferable.

It is preferable that the phosphate-containing organic compound be a phosphate ester from the viewpoint of improving the atmospheric stability of the dispersion. For example, a phosphate monoester represented by the following general formula (1):

[Chem. 4]

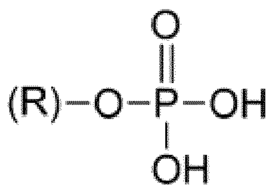

(1)

wherein R is a monovalent organic group, is preferable in that the phosphate monoester has excellent adsorption to metal oxide particles and exhibits moderate adhesive property to the base material, which contributes to both stable formation of the metal wire and satisfactory development of unexposed portions. Examples of the R include substituted and unsubstituted hydrocarbon groups.

As one example of the phosphate monoester, a compound having a structure represented by the following formula (2):

[Chem. 5]

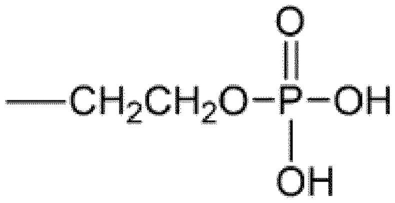

(2)

can be exemplified.

As one example of the phosphate monoester, a compound having a structure represented by the following formula (3):

[Chem. 6]

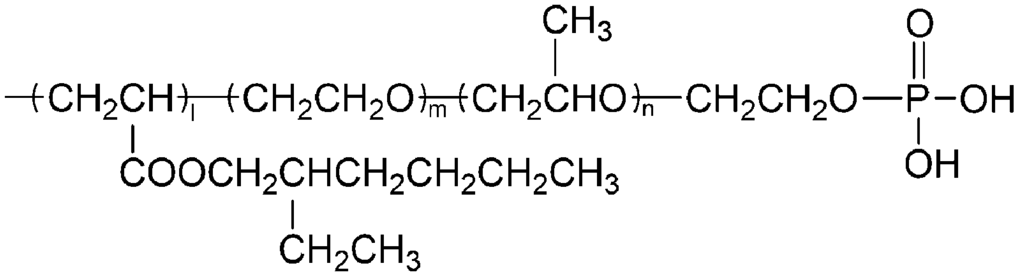

(3)

wherein l, m, and n are each independently an integer of 1 to 20, can be exemplified.

In the above formula (3), l is an integer of 1 to 20, preferably an integer of 1 to 15, and more preferably an integer of 1 to 10; m is an integer of 1 to 20, preferably an integer of 1 to 15, and more preferably an integer of 1 to 10; and n is an integer of 1 to 20, preferably an integer of 1 to 15, and more preferably an integer of 1 to 10.

The organic structures constituting the phosphorus-containing organic compound may have a structure derived (specifically, through functional group denaturation, functional group modification, or polymerization) from compounds such as polyethylene glycol (PEG), polypropylene glycol (PPG), polyimide, polyesters (for example, polyethylene terephthalate (PET) and polyethylene naphthalate (PEN)), polyether sulfone (PES), polycarbonate (PC), polyvinyl alcohol (PVA), polyvinyl butyral (PVB), polyacetal, polyarylate (PAR), polyamide (PA), polyamideimide (PAI), polyetherimide (PEI), polyphenylene ether (PPE), polyphenylene sulfide (PPS), polyether ketone (PEK), polyphthalamide (PPA), polyethernitrile (PENt), polybenzimidazole (PBI), polycarbodiimide, polysiloxanes, polymethacrylamide, nitrile rubber, acrylic rubber, polyethylene tetrafluoride, epoxy resins, phenolic resins, melamine resins, urea resins, polymethyl methacrylate resin (PMMA), polybutene, polypentene, ethylene-propylene copolymers, ethylene-butene-diene copolymers, polybutadiene, polyisoprene, ethylene-propylene-diene copolymers, butyl rubber, polymethylpentene (PMP), polystyrene (PS), styrene-butadiene copolymers, polyethylene (PE), polyvinyl chloride (PVC), polyvinylidene fluoride (PVDF), polyether ether ketone (PEEK), phenolic novolacs, benzocyclobutene, polyvinylphenol, polychloroprene, polyoxymethylene, polysulfone (PSF), polysulfides, silicone resins, aldose, cellulose, amylose, pullulan, dextrin, glucan, fructan, and chitin. A phosphorus-containing organic compound having a polymer framework selected from polyethylene glycol, polypropylene glycol, polyacetal, polybutene, and polysulfide is easily decomposed and does not easily leave residue in the metal wire obtained after firing, and is thus preferable.

Commercially available materials can be used as specific examples of the phosphorus-containing organic compound. Specific examples thereof can include DISPERBYK™-102, DISPERBYK-103, DISPERBYK-106, DISPERBYK-109, DISPERBYK-110, DISPERBYK-111, DISPERBYK-118, DISPERBYK-140, DISPERBYK-145, DISPERBYK-168, DISPERBYK-180, DISPERBYK-182, DISPERBYK-187, DISPERBYK-190, DISPERBYK-191, DISPERBYK-193, DISPERBYK-194N, DISPERBYK-199, DISPERBYK-2000, DISPERBYK-2001, DISPERBYK-2008, DISPERBYK-2009, DISPERBYK-2010, DISPERBYK-2012, DISPERBYK-2013, DISPERBYK-2015, DISPERBYK-2022, DISPERBYK-2025, DISPERBYK-2050, DISPERBYK-2152, DISPERBYK-2055, DISPERBYK-2060, DISPERBYK-2061, DISPERBYK-2164, DISPERBYK-2096, DISPERBYK-2200, BYK™-405, BYK-607, BYK-9076, BYK-9077, and BYK-P105 manufactured by BYK-Chemie; and PLYSURF™ M208F and PLYSURF DBS manufactured by DKS Co., Ltd. These may be used singly, or a plurality thereof may be mixed and used.

In the dispersion and the dried coating, the content of the additive (B), particularly the dispersant, can be 5 parts by volume or more and 900 parts by volume or less when the total volume of the metal particles and metal oxide particles is 100 parts by volume. The lower limit thereof is preferably 10 parts by volume or more, more preferably 30 parts by volume

or more, and even more preferably 60 parts by volume or more. The upper limit thereof is preferably 480 parts by volume or less and more preferably 240 parts by volume or less.

When converted to parts by mass, the content of the additive (B), particularly the dispersant, is preferably 1 part by mass or more and 150 parts by mass or less relative to a total of 100 parts by mass of the metal particles and metal oxide particles. The lower limit thereof is preferably 2 parts by mass or more, more preferably 5 parts by mass or more, and even more preferably 10 parts by mass or more. The upper limit thereof is preferably 80 parts by mass or less and more preferably 40 parts by mass or less. When the above content of the additive (B) is 5 parts by volume or more or 1 part by mass or more, a thin film having a submicron thickness can be easily formed. When the above content of the additive (B) is 10 parts by volume or more or 5 parts by mass or more, a thin film having, for example, a thickness of several tens of μm can be easily formed. When the above content of the additive (B) is 30 parts by volume or more or 10 parts by mass or more, a highly flexible dried coating that is resistant to cracking even when bent can be obtained. When the above content of the additive (B) is 900 parts by volume or less or 150 parts by volume or less, a satisfactory metal wire can be obtained by firing.

The content ratio of the additive (B) in the dispersion is preferably 0.10% by mass or greater, 0.20% by mass or greater, 0.50% by mass or greater, or 1.0% by mass or greater, and is preferably 20% by mass or less, 15% by mass or less, 10% by mass or less, or 8.0% by mass or less in the total dispersion. When the content ratio is 20% by mass or less, the conductive film obtained by firing tends to have satisfactory conductivity without increasing residue from the additive (B). When the content ratio is 0.10% by mass or greater, the metal particles and/or metal oxide particles do not aggregate and satisfactory dispersibility can be obtained.

A reductant as the additive (B) is used during synthesis of metal particles and/or metal oxide particles and may thereby remain in the dispersion, and thus may remain in the dried coating. The reductant preferably comprises hydrazine and/or hydrazine hydrate, and more preferably is hydrazine and/or hydrazine hydrate. When the dispersion comprises metal oxide particles and the dried coating comprises a reductant, the metal oxide (for example, copper oxide) is easily reduced to the metal (for example, copper) when the dried coating is irradiated with laser light, and resistance of the metal (for example, copper) after reduction can be lowered. The reductant remains in an unexposed portion (i.e., a region not irradiated with laser light) of the dried coating.

The mass ratio of the content ratios of the reductant in the dispersion and in the dried coating to the total content ratio of the metal particles and/or metal oxide particles is preferably 0.0001 or greater, 0.0010 or greater, 0.0020 or greater, or 0.0040 or greater from the viewpoint of obtaining a satisfactory reduction effect, and is preferably 0.10 or less, 0.050 or less, or 0.030 or less from the viewpoint of obtaining low-resistance metal wire by avoiding excessive reductant residue.

The total content (based on amount of hydrazine) of hydrazine and hydrazine hydrate in the dispersion and the dried coating and the content of copper oxide preferably satisfy the following relation.

$$0.0001 \leq (\text{hydrazine mass/copper oxide mass}) \leq 0.10$$

Suitable examples of a complexing agent as the additive (B) are the same as those exemplified for the additive (A). The content ratio of the complexing agent in the dispersion is preferably 0.1% by mass or greater, 0.2% by mass or greater, 0.5% by mass or greater, or 1.0% by mass or greater from the viewpoint of satisfactorily dispersing the metal particles and/or metal oxide particles, and is preferably 20% by mass or less, 15% by mass or less, 10% by mass or less, or 8.0% by mass or less from the viewpoint of satisfactory conductivity without increasing residue of the complexing agent in the conductive film obtained by firing.

((iii) Dispersion medium)

A dispersion medium can be contained in the dispersion, and in one aspect, in the dried coating to disperse the metal particles and/or metal oxide particles.

As specific examples of the dispersion medium, alcohols (monohydric alcohols and polyhydric alcohols (for example, glycols), ethers of alcohols (for example, glycols), and esters of alcohols (for example, glycols)) can be used. More specific examples thereof include propylene glycol monomethyl ether acetate, 3-methoxy-3-methyl-butyl acetate, ethoxyethyl propionate, propylene glycol monomethyl ether, propylene glycol monoethyl ether, propylene glycol monopropyl ether, propylene glycol tertiary butyl ether, dipropylene glycol monomethyl ether, ethylene glycol butyl ether, ethylene glycol ethyl ether, ethylene glycol methyl ether, xylene, mesitylene, ethylbenzene, octane, nonane, decane, ethylene glycol, 1,2-propylene glycol, 1,3-butylene glycol, 2-pentanediol, 2-methylpentane-2,4-diol, 2,5-hexanediol, 2,4-heptanediol, 2-ethylhexane-1,3-diol, diethylene glycol, dipropylene glycol, hexanediol, octanediol, triethylene glycol, tri-1,2-propylene glycol, ethyl glycerol acetate, n-propyl acetate, isopropyl acetate, pentane, hexane, cyclohexane, methylcyclohexane, toluene, methyl ethyl ketone, methyl isobutyl ketone, dimethyl carbonate, methanol, ethanol, n-propanol, i-propanol, n-butanol, i-butanol, sec-butanol, t-butanol, n-pentanol, i-pentanol, 2-methylbutanol, sec-pentanol,

t-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, phenol, cyclohexanol, methylcyclohexanol, 3,3,5-trimethylcyclohexanol, benzyl alcohol, and diacetone alcohol.

Of these, monoalcohols and polyhydric alcohols having 10 carbon atoms or less are more preferable from the viewpoint of dispersibility of metal particles and/or metal oxide particles. Of the monoalcohols having 10 carbon atoms or less, ethanol, n-propanol, i-propanol, n-butanol, i-butanol, sec-butanol, and t-butanol are even more preferable. These alcohols may be used singly, or a plurality thereof may be mixed and used.

The solid content ratio of the dispersion is preferably 0.6% by mass or greater, 1.2% by mass or greater, 6.0% by mass or greater, and is preferably 80% by mass or less, 75% by mass or less, or 58% by mass or less. The solid content ratio of the dispersion can be determined by weighing 0.5 to 1.0 g of the dispersion and dividing the weight after heating by the weight before heating when heated in air at 60 °C for 4.5 h. In one aspect, the solid content ratio of the dispersion corresponds to the content ratio of the metal particles and/or metal oxide particles in the dispersion. When the solid content ratio is 0.6% by mass or greater and 80% by mass or less, the dispersion can have a viscosity suitable for application on a base material.

The viscosity of the dispersion is preferably 0.1 mPa•s or more or 1 mPa•s or more, and is preferably 100,000 mPa•s or less, 10,000 mPa•s or less, or 1,000 mPa•s or less. When the viscosity is 0.1 mPa•s or more and 100,000 mPa•s or less, the dispersion can be applied more uniformly to the base material. As described herein, the viscosity is a value measured with an E-type viscometer.

The pH of the dispersion is preferably 4.0 or greater, 5.0 or greater, or 6.0 or greater from the viewpoint of preventing dissolution of the metal particles and/or metal oxide particles in the dispersion. The pH may be, for example, 10.0 or less, 9.0 or less, or 8.0 or less from the viewpoint of reducing damage to the base material.

The surface free energy of the dispersion is preferably 10 mN/m or more, 12 mN/m or more, or 15 mN/m or more, and is preferably 50 mN/m or less, 35 mN/m or less, or 25 mN/m or less, in that the dispersion can be applied evenly and uniformly to the base material.

The thickness of the dried coating is preferably 0.1 μm or more, 0.5 μm or more, or 1.0 μm or more from the viewpoint of easily manufacturing a metal wire having low resistance and excellent mechanical properties, and may preferably be 50 μm or less, 25 μm or less, or 10 μm or less from the viewpoint of manufacturing the metal wire with high precision.

[Base material]

The base material constitutes the surface on which the metal wire is arranged. The material of the base material is preferably an insulating material to ensure electrical insulating property between metal wires formed by laser light. However, it is not necessary that the entire base material be an insulating material. It is sufficient as long as the portion constituting the surface on which the metal wire is arranged is made of an insulating material.

The material of the base material is preferably a material having a heat resistance temperature of 60 °C or higher to prevent the base material from being burned by the laser light and generating smoke when irradiated with the laser light. It is not necessary that the base material be composed of a single material. For example, glass fibers may be added to resin to increase the heat resistance temperature.

The surface of the base material on which the dried coating is disposed may be a flat surface or a curved surface, or may be a surface including steps. More specifically, the base material may be a substrate (for example, a plate-like body, a film, or a sheet) or a three-dimensional object (for example, casing). The plate-like body is, for example, a support used for a circuit board such as a printed board. The film or sheet is, for example, a base film, which is a thin-film insulator, used for flexible printed circuit boards.

Examples of the three-dimensional object include casings of electrical equipment such as mobile phone terminals, smartphones, smart glasses, televisions, and personal computers. Other examples of the three-dimensional object, in the field of automobiles, include dashboards, instrument panels, steering wheels, and chassis.

Specific examples of the base material include base materials made of inorganic materials (hereinafter, referred to as "inorganic base material") or base materials made of resins (hereinafter, referred to as "resin base material").

The inorganic base material is composed of, for example, glass, silicon, mica, sapphire, crystal, clay film, or a ceramic material. The ceramic material is selected from, for example, alumina, silicon nitride, silicone carbide, zirconia, yttria, aluminum nitride, and mixtures of at least two thereof. A base material composed of glass, sapphire, or crystal, each of which has particularly high light transmittance, can be used as the inorganic base material.

As the resin base material, supports made from, for example, polypropylene (PP), polyimide (PI), polyesters (such as polyethylene terephthalate (PET), polyethylene naphthalate (PEN), and polybutylene terephthalate (PBT)), polyether sulfone (PES), polycarbonate (PC), polyvinyl alcohol (PVA), polyvinyl butyral (PVB), polyacetal (POM), polyarylate (PAR), polyamide (PA) (such as PA6 and PA66), polyamideimide (PAI), polyetherimide (PEI), polyphenylene ether (PPE), modified polyphenylene ether (m-PPE), polyphenylene sulfide (PPS), polyetherketone (PEK), polyetheretherketone (PEEK), polyphthalamide (PPA), polyethernitrile (PENt), polybenzimidazole (PBI), polycarbodiimide, polymethacrylamide, nitrile rubber, acrylic rubber, polyethylene tetrafluoride, epoxy resins, phenolic resins, melamine resins, urea resins, polymethyl methacrylate resin (PMMA), polybutene, polypentene, ethylene-propylene copolymers, ethylene-butene-diene copolymers, polybutadiene, polyisoprene, ethylene-propylene-diene copolymers, butyl rubber, polymethylpentene (PMP), polystyrene (PS), styrene-butadiene copolymers, polyethylene (PE), polyvinyl chloride (PVC), polyvinylidene fluoride (PVDF), and phenolic novolacs, benzocyclobutene, polyvinylphenol, polychloroprene, polyoxymethylene, polysulfone (PSF), polyphenylsulfone resin (PPSU), cycloolefin polymer (COP), acrylonitrile-butadiene-styrene resin (ABS), acrylonitrile-styrene resin (AS), polytetrafluoroethylene resin (PTFE), polychlorotrifluoroethylene (PCTFE), and silicone resins can be used.

In addition to the above, resin sheets containing, for example, cellulose nanofibers can be used as the base material.

Particularly, at least one selected from the group consisting of PI, PET, and PEN has excellent adhesive property to the metal wire and good commercial distribution and availability at low cost, which is significant from a business viewpoint, and is thus preferable.

At least one selected from the group consisting of PP, PA, ABS, PE, PC, POM, PBT, m-PPE, and PPS, particularly when used for a casing, has excellent adhesive property, excellent moldability, and excellent mechanical strength after molding. Further, these materials have sufficient heat resistance to withstand heat generated by laser light irradiation when forming metal wire, and are thus preferable.

The material of the three-dimensional object is preferably, for example, at least one selected from the group consisting of polypropylene resin, polyamide resin, acrylonitrile-butadiene-styrene resin, polyethylene resin, polycarbonate resin, polyacetal resin, polybutylene terephthalate resin, modified polyphenylene ether resin, and polyphenylene sulfide resin.

The load deflecting temperature of the resin base material is preferably 400 °C or lower, more preferably 280 °C or lower, and even more preferably 250 °C or lower. A base material having a load deflecting temperature of 400 °C or lower is available at low cost, which is excellent from a business viewpoint, and thus preferable. The load deflecting temperature is preferably 70 °C or higher, 80 °C or higher, 90 °C or higher, or 100 °C or higher from the viewpoint of handleability of the resin base material. The load deflecting temperature of the present disclosure is a value obtained in accordance with JIS K7191.

When the base material is, for example, a plate-like body, film, or sheet, the thickness thereof is preferably 1 μm or more or 25 μm or more, and is preferably 100 mm or less, 10 mm or less, or 250 μm or less. It is preferable that the thickness of the base material be 250 μm or less in that an electronic device to be fabricated can be made lightweight, space-saving, and flexible.

Note that, when the base material is a three-dimensional object, the maximum dimension (i.e., a maximum length of one side) is preferably 1 μm or more or 200 μm or more, and is preferably 1000 mm or less, 100 mm or less, or 5 mm or less from the viewpoint of exhibiting satisfactory mechanical strength and heat resistance of the base material.

[Arithmetic average surface roughness Ra of base material]

Examples of the base material, on the surface of which the metal wire is arranged, as described below, include base materials made of an inorganic material (hereinafter, "inorganic base material") and base materials made of a resin (hereinafter, referred to as "resin base material"). In one aspect, the base material has a surface having a surface roughness controlled within a specific range. In one aspect, the arithmetic average surface roughness of the surface is 70 nm or more and 10000 nm or less, is preferably 100 nm or more or 150 nm or more, and is preferably 5000 nm or less or 1000 nm or less.

As described herein, the arithmetic average surface roughness Ra is a value measured using a stylus surface profilometer as described in the [Examples] section of the present disclosure. Note that, the surface roughness of a base material on which a coating has already been disposed can be measured by the following method. The base material on which the coating is disposed is immersed in 0.6% by mass of nitric acid or hydrochloric acid, in an amount such that the entire base material is immersed, and shaken at a speed of 60 rpm for 12 h or more to dissolve the coating. When the coating is completely dissolved, the base material is washed with 50 ml or more of ultrapure water, and then measured with the stylus surface profilometer as described in the [Examples] section.

When the arithmetic average surface roughness is 70 nm or more, the dispersion enters into the recesses of the unevenness of the base material surface due to an anchor effect, and thus the dried coating and the base material are satisfactorily brought into close contact with each other, and metal wire that is difficult to peel off even when a developing operation is carried out is formed. As a result, the metal wire is subjected to less damage during the developing operation, and the resistance of the metal wire does not easily increase after development. When the arithmetic average surface roughness Ra is 10000 nm or less, the unevenness on the surface of the base material is not excessively large, and thus a coating having a uniform thickness can be formed on the surface. Consequently, metal wire that does not easily break and

has little variation in resistance between parts can be obtained. Having an arithmetic average surface roughness Ra of 10000 nm or less is advantageous from the viewpoint of good development and removal properties of unexposed portions.

[Steps in method for manufacturing metal wire]

Hereinafter, with reference to FIGS. 1 to 7, exemplifying aspects of each step in the method for manufacturing a metal wire according to the present embodiment will be described.

(Preparation of dispersion)

In one aspect, the dispersion is prepared prior to the application step. An example of preparing a dispersion comprising cuprous oxide particles will be described below.

Cuprous oxide particles can be synthesized, for example, by the following methods.

(1) A method in which water and a copper acetylacetonate complex (hereinafter, referred to as an organocopper compound) are added to a polyol solvent, the organocopper compound is once dissolved by heating, water in an amount necessary for reaction is further added thereto, and the mixture is heated to the reduction temperature of the organocopper for reduction

(2) A method in which an organocopper compound (copper-N-nitrosophenylhydroxylamine complex) is heated in a high temperature of about 300 °C in an inert atmosphere in the presence of a protectant such as hexadecylamine

(3) A method in which a copper salt dissolved in a solvent (for example, water) is reduced with a reductant (for example, hydrazine)

Of the above methods (1) to (3), the method (3) is preferable since the operation is simple and particles having a small particle size can be obtained.

The above method (1), for example, can be carried out under the conditions described in the 2001 Angewandte Chemie International Edition, No. 40, Vol. 2, p. 359.

The above method (2), for example, can be carried out under the conditions described in the Journal of American Chemical Society, 1999, Vol. 121, p. 11595.

With reference to FIGS. 1 and 6, in the method (3), a solvent A, a copper salt B, and a reductant C are supplied to a container, and the copper salt B is reduced with the reductant C to obtain copper oxide particles (FIG. 1(a)). As the copper salt, a divalent copper salt can be suitably used. Examples thereof can include copper(II) acetate, copper(II) nitrate, copper(II) carbonate, copper(II) chloride, and copper(II) sulfate. The amount of hydrazine used is preferably 0.2 mol or more or 0.25 mol or more, and is preferably 2 mol or less or 1.5 mol or less relative to 1 mol of the copper salt.

The solvent A may include water and also water-soluble organic substances. Addition of a water-soluble organic substance to an aqueous solution in which a copper salt is dissolved lowers the melting point of the aqueous solution, thereby allowing reduction at a lower temperature. As the water-soluble organic substance, for example, an alcohol or a water-soluble polymer can be used.

As the alcohol, for example, methanol, ethanol, 1-propanol, 1-butanol, 1-hexanol, 1-octanol, 1-decanol, ethylene glycol, propylene glycol, or glycerin can be used. As the water-soluble polymer, for example, polyethylene glycol, polypropylene glycol, or a polyethylene glycol-polypropylene glycol copolymer can be used.

The temperature for the reduction in the above method (3) can be set to, for example, -20 °C to 60 °C, and is preferably -10 °C to 30 °C. The reduction temperature may be constant during the reaction, may be increased or decreased during the reaction. At the initial stage of the reaction when hydrazine is highly active, the reduction is preferably carried out at 10 °C or lower, and more preferably 0 °C or lower. The reduction time is preferably 30 min to 300 min, and more preferably 90 min to 200 min. The atmosphere for reduction is preferably an inert atmosphere such as nitrogen or argon.

The reaction solution is then centrifuged (step S101) to obtain a supernatant 2a and a precipitate 2b (FIG. 1(b)). The precipitate 2b is collected (step S102), and copper oxide particles as the precipitate 2b are thereby obtained.

A commercially available product may be used as the copper oxide particles. Examples of the commercially available products include cuprous oxide particles having an average primary particle size of 18 nm available from EM Japan.

To the precipitate 2b, a dispersion medium D and, in one aspect, an additive (B) E (in one aspect, a dispersant) are added and stirred by a known method such as a homogenizer to disperse the copper oxide particles in the dispersion medium (FIG. 1(c)). Note that, depending on the dispersion medium, the copper oxide particles may not be easily dispersed and the dispersion may be insufficient. In such a case, it is preferable that, for example, an alcohol in which copper oxide particles are easily dispersed, such as butanol, be used to disperse the copper oxide, and then the solvent be replaced with a desired dispersion medium and/or enriched to a desired concentration (step S103). Examples include a method of enriching with an ultrafiltration (UF) membrane and a method of repeating dilution and enrichment with a desired

dispersion medium.

For example, the desired dispersion can be obtained as an unused dispersion 2c by the procedure as described above (FIG. 1(d)).

(Polishing of base material)

In one aspect, the dispersion-coated surface of the base material 1 (FIG. 1(e)) has a controlled (specifically within the range of the present disclosure) arithmetic average surface roughness. A typical aspect of the method of the present disclosure may include polishing the surface of the base material 1 (step S201) prior to the application step, whereby the substrate 1 may have a polished surface S (FIG. 1(f)). Polishing is advantageous in that the arithmetic average surface roughness of the base material surface can be easily controlled. As described herein, polishing encompasses both smoothing and roughening. The method of polishing is not particularly limited. Examples thereof include physical polishing methods using, for example, a whetstone (such as a rotary whetstone), file, sandpaper, or abrasive and chemical polishing methods such as electropolishing and solvent immersion. An appropriate polishing method may be selected according to the material and surface morphology of the base material surface to be polished and the desired arithmetic average surface roughness.

(Application step)

In the present step, the dispersion of the present disclosure (which may be an unused dispersion 2c and/or a regenerated dispersion 3c described below) is applied onto the surface of the base material 1 having an optionally controlled arithmetic average surface roughness (step S11) to form a dispersion layer 2d (FIG. 1(g)). The method of forming the dispersion layer is not particularly limited. Application methods such as die coating, spin coating, slit coating, bar coating, knife coating, spray coating, and dip coating can be used. Using these methods to apply the dispersion in a uniform thickness on the base material is desirable.

(Drying step)

In the present step, the base material 1 and the dispersion layer 2d formed on the base material are dried (step S12), and a structure 10 with dried coating, comprising the base material 1 and the dried coating 2e disposed on the base material 1, is formed (FIG. 1(h)). The drying conditions may be adjusted so that the solid content is controlled within the desired range (range recited in one aspect herein).

The drying temperature is preferably 40 °C or higher, 50 °C or higher, or 60 °C or higher, in that the drying time can be shortened and industrial productivity can be improved, and is preferably 120 °C or lower, 110 °C or lower, 100 °C or lower, or 90 °C or lower, in that deformation of the base material (particularly a resin base material) can be suppressed. The drying time is preferably 8 h or less, 4 h or less, or 2 h or less, from the viewpoint of preventing excessive volatilization of the dispersion medium in the dispersion layer to control the solid content of the dried coating below a desired level, thereby facilitating dispersion of the dried coating during development (i.e., from the viewpoint of improving developability), and is preferably 10 min or more, 20 min or more, or 30 min or more, in that a very small amount of dispersion medium contained in the dried coating reacts with the base material (particularly, a resin base material), the base material dissolves and diffuses into the dried coating, the bond between the dried coating and the base material is strengthened, and deterioration of developability can be suppressed, and in that the content ratio of the organic components contained in the metal wire formed in the laser light irradiation step described below is decreased and a metal wire having low resistance can be manufactured. The drying pressure may typically be normal pressure. From the viewpoint of increasing industrial productivity, drying may be carried out at reduced pressure, preferably at - 0.01 MPa or less or -0.03 MPa or less in terms of gauge pressure. The gauge pressure may preferably be -0.10 MPa or more or -0.08 MPa or more from the viewpoint of gradually volatilizing the dispersion medium to form a dried coating of satisfactory quality.

The solid content of the dried coating is preferably 60% by mass or greater, 65% by mass or greater, or 70% by mass or greater, and is preferably 99% by mass or less, 95% by mass or less, or 90% by mass or less. As described herein, the solid content of the dried coating can be measured using a TG-DTA (thermogravimetric differential thermal analysis) apparatus, as described in the [Examples] section of the present disclosure. When the solid content of the dried coating is 60% by mass or greater, the volume shrinkage of the dried coating when irradiated with laser light to obtain a metal wire is small, the amount of voids in the metal wire is small, and the sinterability is higher, and thus wire having low resistance and small variation in resistance between parts can be obtained. When the solid content of the dried coating is 60% by mass or more, the adhesive strength or bonding strength between an unexposed portion and the base material is small, and good development and removal properties can be obtained. For example, when the base material is a resin base material, the base material is slightly dissolved by the dispersion medium in the dried coating, and the base material components diffuse in the dried coating, whereby unexposed portions and the base material may become firmly bonded. However, such

diffusion can be avoided if the solid content is 60% by mass or greater. When the solid content of the dried coating is 99% by mass or less, the metal particles and/or metal oxide particles in the dried coating are satisfactorily dispersed in the developer, and residual amount of metal particles and/or metal oxide particles on the base material after development can be decreased (i.e., developability is satisfactory).

In one aspect, the arithmetic average surface roughness Ra of the surface (i.e., surface of the dried coating opposite to the base material side) of the structure with a dried coating is 70 nm or more and 10000 nm or less. The above arithmetic average Ra is preferably 70 nm or more, 100 nm or more, or 150 nm or more from the viewpoints of increasing the contact area with the developer and improving dispersibility in the dried coating, and is preferably 10000 nm or less, 5000 nm or less, or 1000 nm or less, from the viewpoint of forming a uniform metal wire with little unevenness.

(Storage step)

In one aspect, a storage step of storing the structure 10 with dried coating for a predetermined period of time may be carried out. The storage step is preferably carried out in an environment with a storage temperature of 0 °C or higher and 40 °C or lower and a relative humidity of 20% or greater and 70% or less. The storage temperature is more preferably 0 °C or higher and 30 °C or lower, and the relative humidity is more preferably 30% or greater and 50% or less. During storage of the structure with a dried coating, degradation and migration of coating components may occur, and the migration causes short-circuiting of the metal wire. When the storage temperature and relative humidity are within the above ranges, the dried coating is stably stored, whereby degradation and migration of coating components can be suppressed. The pressure during storage may typically be normal pressure, but may be carried out at reduced pressure, preferably to -0.01 MPa or less, -0.03 MPa or less, -0.05 MPa or less, or -0.1 MPa or less in terms of gauge pressure. The gauge pressure may preferably be -0.10 MPa or more or -0.08 MPa or more, from the viewpoint of maintaining a stable quality of the dried coating in the storage step.

The storage time of the structure with a dried coating is preferably 10 min or more, 20 min or more, or 30 min or more, in that heat in the drying step can be dissipated, and the change in coating composition due to moisture adsorption of the moisture in the air into the dried coating is suppressed so that variation in resistance of the metal wire formed by laser light irradiation in the laser light irradiation step described below can be suppressed, and is preferably 60 days or less, 30 days or less, or 7 days or less, in that deterioration of developability due to a very small amount of the dispersion medium contained in the dried coating reacting with the base material (particularly a resin base material), the base material dissolving and diffusing into the dried coating, and the bond between the dried coating and the base material strengthening can be prevented.

(Laser light irradiation step)

In the present step, the dried coating 2e is irradiated with laser light L (step S13) to form a conductive portion 2fa, which is an exposed portion, in a portion of the dried coating 2e (FIG. 1(i)). Consequently, a structure 20 with a conductive portion, comprising the base material 1 and irradiated coating 2f disposed on the base material 1 and composed of the conductive portion 2fa, which is an exposed portion, and a non-conductive portion 2fb, which is an unexposed portion, is formed (FIG. 1(j)). The conductive portion 2fa constitutes the metal wire. For example, when a dispersion comprising copper oxide particles is used in the laser light irradiation step, the copper oxide in the dried coating is reduced to generate copper particles, and a heat treatment is carried out under conditions which cause the generated copper particles to integrate by fusing to each other, thereby forming the metal wire.

For laser light irradiation, a known laser light irradiation apparatus having a laser light irradiation portion may be used. Laser light is preferable in that high-intensity light exposure occurs for a short period of time, and the dried coating formed on the base material can be raised to a high temperature and fired for a short period of time. Laser light is advantageous in that the firing time can be shortened, and thus damage to a base material is small and the laser light can be applied to a base material having low heat resistance (for example, a resin film substrate). Further, laser light has a large degree of freedom in wavelength selection, which is advantageous in that the wavelength can be selected in consideration of the light absorption wavelength of the dried coating and/or the light absorption wavelength of the base material.

Since beam scanning is possible with laser light, adjusting the exposure range is easy. For example, selective light irradiation (drawing) only to a target region of the dried coating is possible without using a mask.

As the type of laser light source, YAG (yttrium aluminum garnet), YVO (yttrium vanadate), Yb (ytterbium), semiconductor (GaAs, GaAlAs, or GaInAs), or carbon dioxide gas can be used. As the laser light, not only the fundamental wave but also the harmonic wave may be extracted and used as needed.

The center wavelength of the laser light is preferably 350 nm or more and 600 nm or less. Particularly, when cuprous oxide is used as the metal oxide, the cuprous oxide absorbs laser light having a center wavelength within the above range, and can thus be uniformly reduced to form a low-resistance metal wire.

The laser light is preferably emitted onto the dried coating through a galvanoscanner. A metal wire of any shape

can be obtained by scanning the dried coating with laser light via a galvanoscanner.

The laser light irradiation output is preferably 100 mW or more, 200 mW or more, or 300 mW or more from the viewpoint of efficiently carrying out the desired firing (for example, reduction of cuprous oxide), and is preferably 1500 mW or less, 1250 mW or less, or 1000 mW or less from the viewpoints of suppressing breakage of the metal wire due to ablation caused by excessive output of the laser light and obtaining a low-resistance metal wire.

In one aspect, the laser light may repeatedly scan desired positions on the dried coating. In this case, the amount of movement of the laser light is preferably set such that adjacent scan lines overlap each other. FIG. 2 is a schematic diagram illustrating overlapping irradiation with laser light in the method for manufacturing a metal wire according to the present embodiment. With reference to FIG. 2, the first scan line R1 and the adjacent second scan line R2 overlap each other. As a result, heat storage amount increases in the overlapping region where the first scan line R1 and the second scan line R2 overlap. The degree of sintering of the copper particles is increased, and as a result, resistance in the metal wire is decreased.

The overlap ratio S is determined by the following formula from a width S1 of the first scan line R1 of the laser light and a width S2 of the second scan line R2 overlapping the first scan line R1 in a direction perpendicular to the scanning length direction.

$$S = S2/S1 \times 100\ (\%)$$

The overlap ratio is preferably 5% or greater, 10% or greater, or 15% or greater, and is preferably 99.5% or less. When the overlap ratio is 5% or greater, the degree of sintering of the metal wire can be increased, and the amount of smoke generated can be suppressed. When the overlap ratio is 99.5% or less, the dried coating can be sintered while moving the laser light in a direction perpendicular to the scanning length direction at an industrially practical speed. Since the degree of sintering of the metal wire can be increased according to an overlap ratio within the above range, compared to, for example, an overlap ratio outside the above range, a metal wire that is hard but not brittle can be manufactured. As a result, for example, even when the metal wire is formed on a flexible substrate and bent, the metal wire can follow the flexible substrate without breaking.

(Development step)

In the present step, the unexposed portion of the dried coating, specifically the portion other than the metal wire which is developed and removed by the developer 3a (step S14), and washed as needed, to complete a metal wire 2g (step S15). As a result, a structure 30 with a metal wire comprising the base material 1 and the metal wire 2g arranged on the base material 1 is obtained (FIG. 1(k)). The mode of development is not particularly limited. For example, the structure with a conductive portion may be immersed in a developer and shaken, or the structure with a conductive portion may be immersed in the developer and then irradiated with ultrasonic waves using an ultrasonic apparatus. The developer may be directly sprayed onto the structure with a conductive portion by spraying.

When the structure with a conductive portion is immerse in a developer for development, the developing operation is preferably repeated twice or more by replacing the developer. By replacing the developer, the effect of dispersing the coating in the developer can be enhanced and developability can be improved.

The development step includes a first development process with a first developer of the present disclosure and a second development process with a second developer of the present disclosure. According to the combination of the first development process and the second development process, by using an appropriate combination of two or more developers, the effect of dispersing the coating in the developer can be enhanced, and exposed portions can be satisfactorily removed. At this time, it is preferable to use the first developer and the second developer separately by exchanging the developers (i.e., no mixing).

The order for the first development process and the second development process is not limited, but it is preferable that development be carried out in the order of the first development process using the first developer of the present disclosure and then the second development process using the second developer of the present disclosure, from the viewpoint of removal efficiency of metal particles and/or metal oxide particles. In a preferred embodiment, development is carried out with a developer comprising the additive (A) and then with a developer not comprising the additive (A). Such a development is preferable in that the amount of additive (A) remaining on the structure with a conductive portion can be decreased.

The development step, in addition to the first and second development processes, may further comprise an additional development process using the additional developer of the present disclosure. The timing of the additional development process is not limited. For example, when the second development process is carried out after the first development process, the additional development process can be carried out before the first development process, between the first development process and the second development process, and/or after the second development

process.

The compositions of the first developer, the second developer, and the additional developer may be different from each other, or two or more thereof may be the same.

When the structure with a conductive portion is immersed in a developer and irradiated with ultrasonic waves using an ultrasonic apparatus, the irradiation time of ultrasonic waves is preferably 1 min or more and 30 min or less. When the irradiation is carried out for 1 min or more, the effect of dispersing the coating adhering to the substrate is high. When the irradiation is carried out for 30 min or less, damage to the metal wire can be suppressed.

In the development step, developability is further improved when washing with water and then washing with a developer comprising the additive (A) (in one aspect, a dispersant) is carried out. Developability is further improved by using an ultrasonic apparatus during water washing and/or developer washing.

In the development step, it is preferable to use a jig to retain the base material of the structure with a conductive portion. The shape of the jig is not particularly limited, but it is desirable to have a shape that can prevent the metal wire from damage or from falling off due to a contact between the bottom surface or the side wall surface of a container containing the developer and the structure with a conductive portion when the developing operation is carried out or due to a contact between a plurality of structures with conductive portion when the structures are developed simultaneously. The jig may be, for example, a jig having recessed portions each for retaining one structure with a conductive portion or a clip for retaining a structure.

FIGS. 3 to 5 are schematic diagrams showing examples of a jig for retaining a structure with a conductive portion in a development step of the method for manufacturing a metal wire according to the present embodiment. FIG. 3 shows an example in which a jig 12 having a rack portion 12a is arranged in a container 11, and structures 20 with a conductive portion comprising a base material 1 and an irradiated coating 2f (i.e., a film having a conductive portion and a non-conductive portion) are placed on the rack portion 12. FIG. 4 shows an example in which a jig 22 having recessed portions 22a formed therein is arranged in a container 21, and structures 20 with a conductive portion comprising a three-dimensional base material 1 and an irradiated coating 2f are inserted into the recessed portions 22a. FIG. 5 shows an example in which a container 31 also functions as a jig by including a jig 32 portion having recessed portions 32a formed therein, and structures 20 with a conductive portion comprising a three-dimensional base material 1 and an irradiated coating 2f are inserted into the recessed portions 32a. The recessed portions 22a and 32a shown in FIGS. 4 and 5 are particularly useful when three-dimensional base materials are used.

Particularly, when structures with a conductive portion are irradiated with ultrasonic waves during development, the rack portion 12 shown in FIG. 3 and the recessed portion 22a or 32a shown in FIG. 4 or 5 satisfactorily prevent contact between the structures with a conductive portion.

It is more preferable that the jig have a structure such as a mesh structure which does not interfere with contact between the developer and the structure with a conductive portion while satisfactorily retaining the structure with a conductive portion.

The jig may further comprise any additional member or have any shape, such as a cover for preventing the structure with a conductive portion from floating in the developer, as desired.

(Regenerated dispersion preparation step)

In one aspect, the dispersion of the present disclosure may be a regenerated dispersion prepared using a developer that has been used for development in a development step (i.e., used developer). In one aspect, the method for manufacturing a metal wire comprises, after the development step, a regenerated dispersion preparation step of preparing a regenerated dispersion using a used developer. It is preferable to recover and reuse the used developer for preparation of the dispersion since waste is decreased, leading to lower costs. When the same compound as the dispersion medium used in preparing the dispersion is used as the solvent for the developer, the developer can be reused more easily.

As the used developer, one or more selected from the first developer, the second developer, and the additional developer of the present disclosure can be used. The used developer preferably comprises the first developer, and more preferably is the first developer. Particularly, when the first developer comprises water and the used first developer is regenerated to obtain a regenerated dispersion, in addition to the advantage of reusing resources, the use of water offers the advantages of low cost and environmentally friendly regeneration. In one aspect, the used first developer can be reused as-is as a raw material for the dispersion by only adjusting the concentration as needed. When the first developer comprising the additive (A) is regenerated to obtain a regenerated dispersion comprising the additive (A) as the additive (B) of the present disclosure, since a regenerated dispersion can be obtained without a new preparation of the additive, resources can be recovered at an even higher efficiency.

With reference to FIGS. 6 and 7, the used developer 3b may be partially or wholly reused. In one aspect, a dispersion, which is a reused dispersion 3c alone or a combination of unused dispersion 2c and regenerated dispersion 3c, is applied to a base material 1 (step S11), dried to form a dried coating (step S12), irradiated with laser light (step S13), developed with a developer (step S14), and washed if desired to complete the wire (step S15). A portion or all of the used

developer 3b is recovered (step S16) and subjected to a regeneration process (step S17) to generated a regenerated dispersion 3c, which is then provided to the above application.

Examples of the regeneration process include concentration adjustment (for example, enrichment or dilution), component adjustment (for example, addition or removal of a predetermined component), purification (for example, removal of impurities such as residues), and dispersion condition adjustment (for example, a dispersion process). Further, components of the used developer may be analyzed prior to the regeneration process. In this case, the regeneration process conditions may be determined based on the obtained component analysis results. When the used developer comprises an additive (A), the regeneration process is preferably carried out under conditions that avoid degradation or loss of the additive (A).

More specific examples of the regeneration process include one or more processes of (1) enrichment, (2) addition of one or more of metal particles and/or metal oxide particles, an additive (in one aspect, a dispersant and/or a reductant), and a dispersion medium, and (3) a dispersion process of components in the used developer. The order of these processes is not particularly limited, but the order of (1), (2), and (3) is preferable.

(1) Enrichment

The method of enriching a used developer is not particularly limited. Examples thereof include a method of evaporating and enriching by heating and depressurizing with an evaporator, a method of enriching using a separation membrane, and a method of once drying by freeze-drying and then redispersing the obtained powder in a dispersion medium. The solid content by enrichment may be adjusted to preferably 5% by mass or greater or 10% by mass or greater, and preferably to 60% by mass or less or 50% by mass or less.

(2) Addition

It is preferable that one or more components exemplified above as components contained in the dispersion, more specifically, one or more of metal particles and/or metal oxide particles, an additive (in one aspect, a dispersant and/or a reductant), and a dispersion medium be added to the used developer to adjust the viscosity and/or solid content ratio thereof. In one aspect, any of the desired components of the dispersion that are not present in the used developer or are present in the used developer in less than desired amount may be added.

(3) Dispersion process

From the viewpoint of obtaining a high-quality regenerated dispersion, it is preferable to subject the components contained in the used developer to a dispersion process. The dispersion method is not particularly limited. For example, the used developer may be placed in a container and continuously shaken with a shaker to promote dispersion by liquid flow, or a mechanical dispersion process may be carried out using a homogenizer. From the viewpoint of stability of the used developer, the dispersion time is preferably 1 min or more. The longer the dispersion time, the better. However, from the viewpoint of production efficiency, the dispersion time may be, for example, 1 h or less. When the addition of (2) above is also carried out, the dispersion process preferably follows the addition of (2) above.

A regenerated dispersion can be prepared via the processes recited above. The types of components contained in the regenerated dispersion, the content ratio of each component, and various properties (such as solid content ratio, viscosity, pH, and surface free energy) may be the same as those described above for the dispersion.

<Kits comprising structure with dried coating, structure with conductive portion, and developer>

An aspect of the present invention also provides a kit comprising a structure with a dried coating and a developer. A structure with a dried coating comprises a base material and a dried coating of the present disclosure disposed on a surface of the base material. The dried coating comprises (i) metal particles and/or metal oxide particles and (ii) an additive (B) (in one aspect, a dispersant and/or a reductant). With reference to FIGS. 1 and 6, a kit according to one aspect comprises a structure 10 with a dried coating and a developer 3a.

Also described herein is a kit comprising a structure with a conductive portion and a developer. A structure with a conductive portion comprises a base material and a film having (1) a conductive portion region and (2) a non-conductive portion region disposed on a surface of the base material. In one aspect, the (1) conductive portion region corresponds to exposed portion of the present disclosure, and the (2) non-conductive portion region corresponds to unexposed portion of the present disclosure. In one aspect, the (1) conductive portion region is a metal wire comprising copper, and the (2) non-conductive portion region comprises cuprous oxide and an additive (B) (in one aspect, a dispersant and/or a reductant). With reference to FIGS. 1 and 6, a kit according to one aspect comprises a structure 20 with a conductive portion and a developer 3a.

In these kits, the arithmetic average surface roughness Ra of the surface of the base material may be within the ranges listed in the present disclosure, and is 70 nm or more and 10000 nm or less in one aspect. The developer comprises, in one aspect, a solvent, which is an organic solvent, water, or a mixture thereof, and an additive (A) (in one aspect, a dispersant). The organic solvent, in one aspect, is one or more selected from the group consisting of alcohol solvents, ketone solvents, ester solvents, amine solvents, and ether solvents. In one aspect, the concentration of the additive (A) (in one aspect, a dispersant) in the developer may be within the ranges listed for a developer of the present disclosure, particularly the first developer, and is 0.01% by mass or greater and 20% by mass or less in one aspect.

In these kits, each of the dried coating and the non-conductive portion may comprise a dispersant, preferably a phosphorus-containing organic compound. In these kits, each of the dried coating and the non-conductive portion may also comprise a reductant, preferably hydrazine and/or hydrazine hydrate.

In these kits, the developer comprises a first developer of the present disclosure and a second developer of the present disclosure. In one aspect, the first developer comprises water and/or an alcohol solvent, and further comprises an additive (A). In one aspect, the second developer comprises an organic solvent.

In one aspect of these kits, the additive (A) contained in the developer and the additive (B) contained in the structure with a dried coating are the same as the main component.

By using the structure with a dried coating of the present disclosure in combination with the developer of the present disclosure, a low-resistance metal wire is formed by laser light irradiation onto the dried coating, unexposed portions are satisfactorily developed and removed without damaging the metal wire, and a high-quality structure with a metal wire comprising a base material and a metal wire arranged on the surface of the base material can be manufactured. Further, by using a combination of the structure with a conductive portion and the developer as described above, the non-conductive portion can be satisfactorily developed and removed without damaging the conductive portion, which is the metal wire, and a high-quality structure with a metal wire can be manufactured.

In a kit comprising a structure with a dried coating and a developer, according to a preferred aspect, the structure with a dried coating comprises a base material and a dried coating disposed on a surface of the base material and composed of (i) metal particles and/or metal oxide particles, (ii) a dispersant, and (iii) a reductant. The arithmetic average surface roughness Ra of the surface of the base material is 70 nm or more and 10000 nm or less. The developer comprises a solvent, which is an organic solvent, water, or a mixture thereof, and a dispersant. The organic solvent is one or more selected from the group consisting of alcohol solvents, ketone solvents, ester solvents, and ether solvents. The concentration of the dispersant in the developer is 0.01% by mass or greater and 20% by mass or less.

According to a preferred aspect. The first developer comprises water and/or an alcohol solvent, and 0.01% by mass or greater and 20% by mass or less of a dispersant. The second developer comprises an organic solvent.

In a kit comprising a structure with a conductive portion and a developer, according to a preferred aspect, the structure with a conductive portion comprises a base material and a film including (1) a conductive portion region and (2) a non-conductive portion region disposed on a surface of the base material. The (1) conductive portion region is a metal wire comprising copper. The non-conductive portion region comprises cuprous oxide, a reductant, and a dispersant. The arithmetic average surface roughness Ra of the surface of the base material is 70 nm or more and 10000 nm or less. The developer comprises a solvent, which is an organic solvent, water, or a mixture thereof, and a dispersant. The organic solvent is one or more selected from the group consisting of alcohol solvents, ketone solvents, ester solvents, and ether solvents. The concentration of the dispersant in the developer is 0.01% by mass or greater and 20% by mass or less.

<Metal wire manufacturing system>

An aspect of the present invention also provides a metal wire manufacturing system. With reference to FIG. 8, in one aspect, the metal wire manufacturing system 100 comprises:

an application mechanism 101 for applying a dispersion comprising metal particles and/or metal oxide particles on a surface of a base material to form a dispersion layer;
a drying mechanism 102 for drying the dispersion layer to form a structure with a dried coating, the structure having the base material and the dried coating disposed on the base material;
a laser light irradiation mechanism 103 for irradiating the dried coating with laser light to form a metal wire; and
a development mechanism 104 for developing and removing a region of the dried coating other than the metal wire by a developer.

The metal wire manufacturing system of the present disclosure can be suitably applied to the method for manufacturing a metal wire of the present disclosure. Therefore, as each element of the metal wire manufacturing system, those having the configuration or function as exemplified above in the method for manufacturing a metal wire may be adopted.

The application mechanism 101 may be, for example, one or more selected from die coaters, spin coaters, slit

coaters, bar coaters, knife coaters, spray coaters, and dip coaters.

The drying mechanism 102 may be one or more selected from ovens, vacuum dryers, nitrogen introduction dryers, IR furnaces, and hot plates.

The laser light irradiation mechanism 103 may have, for example, a laser light oscillator (not illustrated) or a galvanoscanner (not illustrated) which irradiates the coating film with oscillating laser light.

In one aspect of the metal wire manufacturing system, the developer (in one aspect, the first developer of the present disclosure) comprises a solvent, which is an organic solvent, water, or a mixture thereof, and an additive (A). In one aspect, the organic solvent is one or more selected from the group consisting of alcohol solvents, ketone solvents, ester solvents, amine solvents, and ether solvents. In one aspect, the concentration of the additive (A) in the developer is 0.01% by mass or greater and 20% by mass or less.

The development mechanism 104 has

(1) a first development portion 104a which develops the dried coating with a first developer; and

(2) a second development portion 104b which develops the dried coating with a second developer. Specific aspects of the first and second developers may be the same as those described above in the method for manufacturing a metal wire. In one aspect, the first developer comprises water and/or an alcohol solvent, and further comprises an additive (A) (in one aspect, a dispersant). In one aspect, the second developer comprises an organic solvent. The positional relationship between the first development portion 104a and the second development portion 104b is not limited, but from the viewpoint of removal efficiency of the metal particles and/or metal oxide particles, it is preferable that the structure with a conductive portion be arranged so as to be supplied to the first development portion 104a and then the second development portion 104b, as shown in FIG. 8.

In one aspect, the development mechanism 104 may comprise, in addition to the first development portion 104a and the second development portion 104b, an additional development portion (not illustrated) which develops the dried coating with the additional developer of the present disclosure.

In one aspect, each of the first development portion 104a and the second development portion 104b, and if present, the additional development portion may have a developer and a container containing the developer and the structure with a conductive portion. Each of the first development portion 104a and the second development portion 104b, and if present, the additional development portion preferably has one or more mechanisms for promoting development, for example, a shaker for shaking the structure with a conductive portion or an ultrasonic wave emitter for irradiating the structure with a conductive portion with ultrasonic waves. In one aspect, each of the first development portion 104a and the second development portion 104b, and if present, the additional development portion may be configured with a developer and a sprayer for spraying the developer onto the structure with a conductive portion.

In one aspect, the metal wire manufacturing system 100 may further comprise a developer regeneration mechanism 105 which regenerates the developer recovered from the development mechanism 104 to produce a regenerated dispersion. The developer regeneration mechanism 105 may be, for example, an enriching apparatus, a diluting apparatus, a mixing apparatus, an impurity removing apparatus, or a dispersing apparatus.

In addition to the elements described above, the metal wire manufacturing system may comprise additional elements such as a base material transport mechanism and a base material washing mechanism, as needed.

<Application example>

As described above, according to the method for manufacturing a metal wire according to the present embodiment and the combination of a structure with a dried coating or a structure with a conductive portion and a developer, a structure with a metal wire having satisfactory developability can be manufactured. The structure with a metal wire according to the present embodiment can be suitable used in, for example, metal wire materials such as electronic circuit boards (printed boards, RFID, and substitutes for wire harnesses in automobiles), antennas formed in casings of portable information devices (such as smartphones), mesh electrodes (electrode films for capacitive touch panels), electromagnetic shielding materials, and heat dissipation materials.

## EXAMPLES

Hereinafter, the present invention will be further specifically described with reference to the Examples and Comparative Examples. However, the present invention is not limited to these Examples and Comparative Examples.

<Evaluation method>

[Arithmetic average surface roughness Ra of base material]

The arithmetic average surface roughness Ra of the surface of the base material to which the dispersion was applied was measured by the following method. Using a stylus surface profilometer (DektakXT manufactured by Bruker Corporation) and an analysis software (Vision64), the surface roughness of the base material was measured. The measurement conditions are as follows.

Scan type: standard scan
Range: 65.5 μm
Profile: Hills & Valleys
Stylus type: 12.5 μm radius
Stylus force: 1 mg
Length: 1000 μm
Retention time: 5 s
Resolution: 0.666 μm/pt

After measuring the profile of the base material surface, surface roughness was analyzed. The analysis conditions for roughness are as follows.

Filter type: Gaussian regression
Long cutoff: long cutoff applied; standard cutoff used (0.25 mm)
Roughness profile: Ra
Parameter calculation: ISO4287
Sample length used in calculation: automatic selection

The average value of surface roughness values obtained under the above conditions and surface roughness values measured in the direction orthogonal to the above measurement direction was used as the arithmetic average surface roughness Ra of the base material.

[Surface free energy]

The surface free energy was measured by the pendant drop method using a contact angle meter (Model DM-700, manufactured by Kyowa Interface Science Co., Ltd.).

[Solubility]

Solubility was measured by the following procedure using an inductively coupled plasma (ICP) emission spectrometry method.
0.10 g of a powder of cuprous oxide particles was charged into 40 ml of a developer and allowed to stand at room temperature of 25 °C for 6 h. The developer comprising the powder was then filtered with a 0.2-μm filter and diluted 100-fold with 0.10 mol/L nitric acid. The metal concentration (unit: mg/L) of the resulting diluted solution was measured using an ICP lightemitting apparatus (Model SPS6100, manufactured SII Nanotechnology Co., Ltd.). From the metal concentration, the concentration (unit: mg/L) of cuprous oxide particles was calculated and used as the solubility of the cuprous oxide particles.

[Resistance of metal wire and change between pre- and post-development resistances]

For each metal wire of the structure with a conductive portion in which three metal wires were formed by laser light irradiation, a tester was applied to a position 0.5 mm from each end in the longitudinal direction to measure the resistance, and a number average value $R_A$ of the three metal wires was calculated. The resistances of the metal wires after the structure with a conductive portion was developed were similarly measured, and a number average value $R_B$ of the three metal wires was calculated. A value of $R_B/R_A$ of 10 or less was judged as acceptable, a value of 5 or less as good, and a value of 2 or less as excellent. If the value of $R_B/R_A$ was greater than 10, or if resistance could not be measured due to disconnection, resistance change was judged as poor.

[Developability of structure with conductive portion]

Developability was evaluated by the following method. A structure with a conductive portion (i.e., structure

comprising copper wire and dried coating not irradiated by laser light) fabricated in the laser light irradiation step was immersed in a developer (23 °C) in an amount in which the entire structure was immersed, and irradiated with ultrasonic waves for a period of 1 min or more and 30 min or less using an ultrasonic apparatus to carry out development.

A portion of the base material after development without a metal wire was cut into 10 mm squares, which were each attached to a SEM (scanning electron microscope) sample stand with carbon tape and coated with platinum-palladium using a coater (MSP-1S manufactured by Vacuum Device). At this time, the coating condition of process time was set to 1.5 min. For the coated sample, residual concentration of the applied metal on the base material surface was measured using SEM (FlexSEM1000 manufactured by Hitachi High-Tech Corporation) and EDX (energy dispersive X-ray analysis) apparatus (AztecOne manufactured by Oxford Instruments). At this time, a sample surface was focused on under the conditions for the electron beamacceleration voltage: 5 kV, spot intensity: 80, and focus position: 10 mm. Thereafter, the entire field of view was mapped and analyzed with a magnification of 200x. The conditions for mapping acquisition were resolution: 256, acquisition time: 50 frames, process time: high sensitivity, pixel dwell time: 150 μs, and frame live time: 0:00:08. The elements to be measured were specified as carbon, oxygen, nitrogen, and the applied metal element (i.e., contained in the dispersion). Platinum and palladium used for coating were not included in the elements to be measured. Measurement was carried out under the above conditions, and the metal element concentration (% by mass) obtained was used as the concentration of metal remaining on the base material due to failure in development.

(Developability evaluation criteria)

In the evaluation of the developability of the above structure with a conductive portion, having a concentration of 20% by mass or less of metal remaining on the base material was considered acceptable; 10% by mass or less was considered good; 2.0% by mass or less was considered excellent; and 1.0% by mass or less was consider superior. When the concentration of the metal remaining on the base material was greater than 20% by mass, or when the coating was obviously not dispersed in the developer during the development operation and the coating remained on the base material, developability was determined to be poor.

<Example 1>

[Manufacture of dispersion]

3224 g of copper(II) acetate monohydrate (manufactured by Nihon Kagaku Sangyo Co., Ltd.) was dissolved in a mixed solvent consisting of 30240 g of water and 13976 g of 1,2-propylene glycol (manufactured by Asahi Glass Co., Ltd.). 940 g of hydrazine hydrate (manufactured by Nippon Finechem Company, Inc.) was added thereto and stirred in a nitrogen atmosphere. The mixture was then separated into a supernatant and a precipitate using centrifugation.

113 g of DISPERBYK-145 (BYK-145) (trade name, manufactured by BYK-Chemie) as the phosphorus-containing organic compound and 916 g of 1-butanol (manufactured by Sankyo Kagaku) as the dispersion medium were added to 858 g of the obtained precipitate, and the mixture was dispersed using a homogenizer to obtain a dispersion containing cuprous oxide (copper(I) oxide) particles comprising cuprous oxide. At this time, the solid content residue (cuprous oxide particles) when the dispersion was heated at normal pressure and 60 °C for 4.5 h was 34.7% by mass.

The surface free energy of the dispersion was measured, and the result is shown in Table 1.

[Polishing of base material]

The surface of an ABS substrate (as a base material) in which the width by depth by thickness was 50 mm × 50 mm × 1 mm was polished using #1000 sandpaper. After polishing, the arithmetic average surface roughness Ra was measured, and the result is shown in Table 1.

[Application and drying of dispersion]

The base material after polishing was cleaned by irradiating the base material with ultrasonic waves in ultrapure water for 5 min and then in ethanol for 5 min, followed by subjecting the surface of the substrate to a UV ozone treatment. Thereafter, 1 ml of the dispersion was dropped onto the surface, spin-coated (300 rpm for 300 s) and dried by heating at 60 °C at 1 h. After drying, the base material was stored in a room at normal pressure, room temperature of 23 °C, and 40% relative humidity for 10 min to obtain a sample having a dried coating formed on the base material.

[Laser light irradiation]

The above sample was placed in a box with a length of 200 mm, a width of 150 mm, and a height of 41 mm, the

upper surface thereof made of quartz glass, with the dried coating facing upward. Compressed air was separated into nitrogen and oxygen by a separation membrane, and the separated nitrogen was blown into the box to make the oxygen concentration inside the box 0.5% by mass or less. While moving the focal position on the base material surface at a maximum speed of 25 mm/s using a galvanoscanner, the dried coating was then repeatedly irradiated with laser light (center wavelength of 355 nm, frequency of 300 kHz, pulse, and output of 79 mW) and scanned, whereby a copper metal wire having a desired dimension of 5 mm in length by 1 mm in width was obtained. At this time, laser light was repeatedly emitted while being moved in the scan line width direction so that the overlap ratio was 93.2%. Two more copper wires were fabricated under the same conditions to obtain a total of three copper wires.

[Resistance wire after laser light irradiation]

The resistance of the obtained metal wire (i.e., pre-development resistance) was measured by the method described above. The pre-development resistance of the three copper wires and the average pre-development resistance value $R_A$, which is the numerical average value from the three copper wires, are shown in Table 1.

[Development of structure with conductive portion]

The structure with a conductive portion after laser light irradiation was immersed in 50 ml (23 °C) of a 2% by mass DISPERBYK-145 aqueous solution (first developer) and irradiated with ultrasonic waves for 5 min by an ultrasonic cleaner (USD-4R manufactured by AS ONE Corporation). The structure was then pulled up with tweezers and washed under running water with 50 ml of ultrapure water. Thereafter, the structure was newly immersed in 50 ml (23 °C) of a 5% by mass diethylenetriamine aqueous solution (second developer) and irradiated with ultrasonic waves for 1 min. The structure was then pulled up with tweezers and washed under running water with 50 ml of ultrapure water.

After the above development operation, the copper concentration was measured at a portion where a metal wire was not present on the base material by the method described above. The results and evaluation are shown in Table 1.

Surface free energy of each developer was measured. The results are shown in Table 1.

Solubility of copper oxide in each developer was measured. The results are shown in Table 1.

[Post-development wire resistance]

After the developing operation, the resistance (i.e., post-development resistance) was measured by the method described above. The post-development resistance values of the three copper wires, the average value $R_B$ of the post-development resistances, the value of $R_B/R_A$, and the evaluations thereof are shown in Table 1.

<Examples 2 and 3>

Except that the base material was polished using #2000 sandpaper, DISPERBYK-145 concentration of the first developer was set as indicated in Table 1, and ultrasonic irradiation time via the first developer was set to 1 min, the same operation as in Example 1 was carried out. The evaluation results are shown in Table 1.

<Example 4>

Except that the base material was polished using #2000 sandpaper, DISPERBYK-145 concentration of the first developer was set as indicated in Table 1, and the procedure for [Developability of structure with conductive portion] was changed to the following, the same operation as in Example 1 was carried out.

[Developability of structure with conductive portion]

The structure with a conductive portion after laser light irradiation was immersed in 50 ml (23 °C) of a 2% by mass DISPERBYK-145 aqueous solution (first developer) and irradiated with ultrasonic waves for 1 min using an ultrasonic cleaner (USD-4R manufactured by AS ONE Corporation). The structure was then pulled up with tweezers and washed under running water with 50 ml of ultrapure water. Thereafter, the structure was newly immersed in 50 ml (23 °C) of a 5% by mass diethylenetriamine aqueous solution (second developer) and irradiated with ultrasonic waves for 1 min. The structure was then pulled up with tweezers and washed under running water with 50 ml of ultrapure water. The structure was further newly immersed in 50 ml (23 °C) of a 5% by mass diethylenetriamine aqueous solution (third developer) and irradiated with ultrasonic waves for 1 min. The structure was then pulled up with tweezers and washed under running water with 50 ml of ultrapure water.

Each evaluation result is shown in Table 1.

<Example 5>

Except that the base material was polished using #2000 sandpaper, [Manufacture of dispersion] was carried out according to the procedure described below, DISPERBYK-145 used in the first developer was changed to DISPERBYK-118 in the same amount, and ultrasonic irradiation time via the first developer was set at 1 min, the same operation as in Example 1 was carried out.

[Production of dispersion]

3230 g of copper(II) acetate monohydrate (manufactured by Nihon Kagaku Sangyo Co., Ltd.) was dissolved in a mixed solvent consisting of 30240 g of water and 13980 g of 1,2-propylene glycol (manufactured by Asahi Glass Co., Ltd.). 940 g of hydrazine hydrate (manufactured by Nippon Finechem Company, Inc.) was added thereto and stirred in a nitrogen atmosphere. The mixture was then separated into a supernatant and a precipitate using centrifugation.

87 g of a mixing solution were added to 38 g of the resulting precipitate, and the mixture was dispersed using a homogenizer to obtain a dispersion containing cuprous oxide (copper(I) oxide) particles comprising cuprous oxide. Note that the above mixing solution was prepared by adding 8 g of a mixed ethanol (manufactured by Sankyo Kagaku) as the dispersion medium to 131 g of DISPERBYK-118 (BYK-118) (trade name, manufactured by BYK-Chemie) as the phosphorus-containing organic compound. The solid content residue (cuprous oxide particles) when the dispersion was heated at normal pressure and 60 °C for 4.5 h was 26.2% by mass.

Each evaluation result is shown in Table 1.

<Examples 6 to 8, 12, and 18 and Reference Example 9>

Except that the base material was polished using #2000 sandpaper, the composition of the developer was changed as indicated in Table 1, and ultrasonic irradiation time via the first developer was set to 1 min, the same operations as in Example 1 were carried out. Each evaluation result is shown in Table 1.

< Reference Example 10>

Except that the base material was polished using #2000 sandpaper, the composition of the developer was changed as indicated in Table 1, and ultrasonic irradiation time via the second developer was set to 15 min, the same operations as in Example 1 were carried out.

Each evaluation result is shown in Table 1.

< Reference Example 11>

Except that the base material was polished using #2000 sandpaper, the composition of the developer was changed as indicated in Table 1, and ultrasonic irradiation time via the second developer was set to 5 min, the same operations as in Example 1 were carried out.

Each evaluation result is shown in Table 1.

<Reference Example 13>

Except that the base material was polished using #2000 sandpaper, ultrasonic irradiation time via the first developer was set to 1 min, and the second development step was not carried out, the same operations as in Example 1 were carried out.

Each evaluation result is shown in Table 1.

<Reference Examples 14 and 15>

Except that the base material was polished using #2000 sandpaper, the composition of the developer was changed as indicated in Table 1, ultrasonic irradiation time via the first developer was set to 1 min, and the second development step was not carried out, the same operations as in Example 1 were carried out.

Each evaluation result is shown in Table 1.

<Reference Example 16>

Except that polishing of the base material was not carried out, the composition of the developer was changed as

shown in Table 1, and ultrasonic irradiation time via the second developer was set to 15 min, the same operations as in Example 1 were carried out.

Each evaluation result is shown in Table 1.

<Reference Example 17>

Except that polishing of the base material was not carried out, the composition of the developer was changed as shown in Table 1, and ultrasonic irradiation time via the second developer was set to 5 min, the same operations as in Example 1 were carried out.

Each evaluation result is shown in Table 1.

<Comparative Example 1>

Except that polishing of the base material was not carried out, the composition of the developer was changed as shown in Table 1, and the second development step was not carried out, the same operations as in Example 1 were carried out.

Each evaluation result is shown in Table 1.

<Comparative Example 2>

Except that the base material was polished using #2000 sandpaper, the composition of the developer was changed as shown in Table 1, ultrasonic irradiation time via the first developer was set to 1 min, and the second development step was not carried out, the same operations as in Example 1 were carried out.

Each evaluation result is shown in Table 1.

[Table 1]

Table 1

| | | Unit | Example 1 | Example 2 | Example 3 | Example 4 | Example 5 | Example 6 | Example 7 | Example 8 | Ref. Example 9 | Ref. Example 10 |
|---|---|---|---|---|---|---|---|---|---|---|---|---|
| Arithmetic average surface roughness Ra of base material | | | 181 | 267 | 185 | 235 | 205 | 208 | 285 | 175 | 227 | 139 |
| Dispersion | Additive (B) type | | DISPERBYK-145 | | | | DISPERBYK-118 | DISPERBYK-145 | | | | |
| | Surface free energy | mN/m | 26 | 26 | 26 | 26 | 22 | 26 | 26 | 26 | 26 | 23 |
| First develop-ment step (first develo-per) | Composition | | Water/DISPERBYK-145 (phosphorus-containing) | | | | Water/DISPERBYK-118 (phosphorus-containing) | Ethanol/DISPERBYK-145 (phosphorus-containing) | Water/DISPERBYK-145 (phosphorus-containing) | Water/DISPERBYK-118 (phosphorus-containing) | Water/DISPERBYK-145 (phosphorus-containing) | |
| | Difference in type between additive (A) and additive (B) | | No | | | | | | | Yes | No | |
| | Additive (A) concentratio n | % by mass | 2 | 0.1 | 20 | 20 | 2 | 2 | 2 | 2 | 2 | 2 |
| | Copper oxide solubility | mg/L | 110 | 22 | 77 | 77 | 260 | 2.7 | 110 | 260 | 110 | 110 |
| | Surface free energy | mN/m | 36 | 48 | 30 | 30 | 40 | 21 | 36 | 40 | 36 | 36 |
| | Absolute value difference in surface free energy be-tween first de-veloper and dispersion | mN/m | 10 | 22 | 3.8 | 3.8 | 17.3 | 4.3 | 10 | 14 | 10 | 13 |

(continued)

| | | Unit | Example 1 | Example 2 | Example 3 | Example 4 | Example 5 | Example 6 | Example 7 | Example 8 | Ref. Example 9 | Ref. Example 10 |
|---|---|---|---|---|---|---|---|---|---|---|---|---|
| Second development step (second developer) | Composition | | Water/diethylenetriamine | | | | | | Water/2-aminoethanel | Water/diethylenetriamine | Water/N-methyl 2-ethanolamine | Water/ DISPERBYK-145 (phosphorus-containing) |
| | concentratio n of organic solvent or additive (A) | % by mass | 5 | 5 | 5 | 5 | 5 | 5 | 5 | 5 | 5 | 2 |
| | Copper oxide solubility | mg/L | 470 | 470 | 470 | 470 | 470 | 470 | 380 | 470 | 95 | 110 |
| Third development step (third developer) | Composition | | - | - | - | Water/diethylentriamine | - | - | - | - | - | - |
| | concentratio n of organic solvent or additive (A) | % by mass | - | - | - | 5 | - | - | - | - | - | - |
| | Copper oxide solubility | mg/L | - | - | - | 470 | - | - | - | - | - | - |
| Developability of structure with conductive portion | Metal concentratio n (copper concentratio n) on base material | % by mass | 0.2 | 2.3 | 4.2 | 0.4 | 4.6 | 5.1 | 2.8 | 6.3 | 9.4 | 2.0 |
| | Developabili ty | | Superior | Excellent | Excellent | Superior | Good | Good | Excellent | Good | Good | Excellent |
| | Pre-development resistance (measured in 3 metal wires) | Ω | 10 | 4.8 | 9 | 18.7 | 13.3 | 10.1 | 10.1 | 6.5 | 10.4 | 3.3 |
| | | | 11 | 6.2 | 12.3 | 21 | 20.6 | 4 | 7.5 | 7.1 | 9.8 | 2.4 |
| | | | 9.9 | 5.7 | 8.3 | 25.8 | 31 | 5.8 | 6.5 | 6.5 | 23 | 5.7 |

(continued)

| | | Unit | Example 1 | Example 2 | Example 3 | Example 4 | Example 5 | Example 6 | Example 7 | Example 8 | Ref. Example 9 | Ref. Example 10 |
|---|---|---|---|---|---|---|---|---|---|---|---|---|
| Wire resistance | Post-development resistance (measured in 3 metal wires) | Ω | 11 | 6.8 | 11.2 | 25 | 17 | 17.8 | 23 | 8.5 | 12.8 | 21 |
| | | | 13 | 5.5 | 27 | 34 | 27 | 13.2 | 7.4 | 7.8 | 12 | 13 |
| | | | 12 | 7.4 | 8.5 | 31 | 37 | 6.2 | 11 | 8.2 | 23 | 16 |
| | Average resistance RA | Ω | 10 | 5.6 | 9.9 | 21.8 | 21.6 | 6.6 | 8.0 | 6.7 | 14.4 | 3.8 |
| | Average resistance RB | Ω | 12 | 6.6 | 15.6 | 30.0 | 27.0 | 12.4 | 13.8 | 8.2 | 15.9 | 17.0 |
| | $R_B/R_A$ | | 1.1 | 1.2 | 1.6 | 1.4 | 1.2 | 1.9 | 1.7 | 1.2 | 1.1 | 4.5 |
| | Resistance change evaluation | | Excellent | Excellent | Excellent | Excellent | Excellent | Excellent | Excellent | Excellent | Excellent | Good |

[Table 2]

Table 1 (continued)

| | | Unit | Ref. Example 11 | Ref. Example 12 | Ref. Example 13 | Ref. Example 14 | Ref. Example 15 | Ref. Example 16 | Ref. Example 17 | Ref. Example 18 | Comparative Example 1 | Comparative Example 2 |
|---|---|---|---|---|---|---|---|---|---|---|---|---|
| Arithmetic average surface roughness Ra of base material | | | 245 | 236 | 300 | 358 | 331 | 68 | 256 | 212 | 230 | 327 |
| Dispersion | Additive (B) type | | DISPERBYK-145 | | | | | | | | | |
| | Surface free energy | mN/m | 26 | 26 | 26 | 26 | 26 | 23 | 26 | 26 | 26 | 26 |

(continued)

Table 1 (continued)

| | | Unit | Ref. Example 11 | Ref. Example 12 | Ref. Example 13 | Ref. Example 14 | Ref. Example 15 | Ref. Example 16 | Ref. Example 17 | Ref. Example 18 | Comparative Example 1 | Comparative Example 2 |
|---|---|---|---|---|---|---|---|---|---|---|---|---|
| First devel-opme nt step (first developer) | Compositio n | | Water/DISPERBYK-145 (phosphorus-containing) | | | | Water/pho sphorus-free dispersant PEG400 | Water/DIS PERBYK-145 (phosphoru s-containing) | Water (No additive (A)) | | | Water/DISPE RBYK-145 (phosphorus-containing) |
| | Difference in type be-tween addi-tive (A) and additive (B) | | No | | | | Yes | No | No additive (A) | | | No |
| | Additive (A) concentrati on | % by mass | 2 | 2 | 2 | 0.05 | 2 | 2 | - | - | - | 25 |
| | Copper oxide solubility | mg/ L | 110 | 110 | 110 | 16 | 3.4 | 110 | 2.8 | 2.8 | 2.8 | 61 |
| | Surface free energy | mN/ m | 36 | 36 | 36 | 48 | 46 | 36 | 71 | 71 | 71 | 28 |
| | Absolute value differ-ence in sur-face free energy be-tween first developer and disper-sion | mN/ m | 10 | 10 | 10 | 22 | 21 | 13 | 46 | 46 | 46 | 2.3 |

(continued)

Table 1 (continued)

| | | Unit | Ref. Example 11 | Ref. Example 12 | Ref. Example 13 | Ref. Example 14 | Ref. Example 15 | Ref. Example 16 | Ref. Example 17 | Ref. Example 18 | Comparative Example 1 | Comparative Example 2 |
|---|---|---|---|---|---|---|---|---|---|---|---|---|
| Second de-velopme nt step (sec-ond develo-per) | Compositio n | | Ethanol | Water | - | - | - | Water/DIS PERBYK-145 (phosphoru s-containing) | Water | Water/DIS PERBYK-145 (phosphoru s-containing) | - | - |
| | concentrati on of organic solvent or additive (A) | % by mass | 100 | - | - | - | - | 2 | - | 2 | - | - |
| | Copper oxide solubility | mg/ L | 1.0 | 2.8 | - | - | - | 110 | 2.8 | 110 | - | - |
| Third developme nt step (third developer) | Compositio n | | | | | | | | | | | |
| | concentrati on of organic solvent or additive (A) | % by mass | - | - | - | - | - | - | - | - | - | - |
| | Copper oxide solubility | mg/ L | - | - | - | - | - | - | - | - | - | - |
| Developabi lity of structure with conductive portion | Metal concentrati on (copper concentrati on) on base material | % by mass | 8.6 | 10.4 | 12.7 | 5.3 | 13.4 | 0.6 | 13.3 | 8.9 | 14.3 | 18.0 |
| | Developabi lity | | Good | Acceptable | Acceptable | Good | Acceptable | Superior | Acceptable | Good | Poor | Poor |

(continued)

Table 1 (continued)

| | | Unit | Ref. Example 11 | Ref. Example 12 | Ref. Example 13 | Ref. Example 14 | Ref. Example 15 | Ref. Example 16 | Ref. Example 17 | Ref. Example 18 | Comparative Example 1 | Comparative Example 2 |
|---|---|---|---|---|---|---|---|---|---|---|---|---|
| | Pre-development resistance (measured in 3 metal wires) | Ω | 6.5 | 36 | 6.5 | 16.9 | 44 | 4.7 | 6.3 | 11.3 | 5.5 | 21 |
| | | | 7.3 | 35 | 8.1 | 10.8 | 16.7 | No conduction | 6.5 | 18 | 4.6 | 14.9 |
| | | | 7.2 | 28 | 11.6 | 8.9 | 36 | 2.8 | 8.4 | 17.9 | 5 | 27 |
| | Post-development resistance (measured in 3 metal wires) | Ω | 8.9 | 39 | 12.1 | 13.9 | 108 | Cannot be measured | 6.6 | 12.1 | 6.5 | 14 |
| | | | 7.3 | 41 | 10 | 13.7 | 23 | Cannot be measured | 7.5 | 26 | 6.8 | 16 |
| | | | 7.3 | 31 | 14.8 | 10.4 | 68 | Cannot be measured | 8.9 | 27 | 5.9 | 34 |
| Wire resistance | Average resistance RA | Ω | 7.0 | 33.0 | 8.7 | 12.2 | 32.2 | 5.5 | 7.1 | 15.7 | 5.0 | 21.0 |
| | Average resistance RB | Ω | 7.8 | 37.0 | 12.3 | 12.7 | 66.3 | - | 7.7 | 21.7 | 6.4 | 21.3 |
| | $R_B/R_A$ | | 1.1 | 1.1 | 1.4 | 1.0 | 2.1 | - | 1.1 | 1.4 | 1.3 | 1.0 |
| | Resistance change evaluation | | Excellent | Excellent | Excellent | Excellent | Good | Poor | Excellent | Excellent | Excellent | Excellent |

INDUSTRIAL APPLICABILITY

According to the present invention, since metal particles and/or metal oxide particles in unexposed portions can be efficiently removed in the development step, a structure with a lowresistance metal wire in which problems such as out-of-pattern deposition in a subsequent plating step and short-circuiting due to migration can be avoided, for example, can be provided.

Such a structure with a metal wire can be suitably used in metal wire materials such as electronic circuit boards; mesh electrodes, electromagnetic shielding materials, and heat dissipating materials.

REFERENCE SIGNS LIST

R1 first scan line
R2 second scan line
S1 width
S2 width
10 structure with dried coating
20 structure with conductive portion
30 structure with metal wire
1 base material
2a supernatant
2b precipitate
2c unused dispersion
2d dispersion layer
2e dried coating
2f irradiated coating
2fa conductive portion
2fb non-conductive portion
2g metal wire
3a developer
3b used developer
3c regenerated dispersion
11, 21, 31 container
12, 22, 32 jig
12a rack portion
22a, 32a recessed portion
100 metal wire manufacturing system
101 application mechanism
102 drying mechanism
103 laser light irradiation mechanism
104 development mechanism
104a first development portion
104b second development portion
105 developer regeneration mechanism

## Claims

**1.** A method for manufacturing a metal wire, comprising:

an application step of applying a dispersion comprising metal particles and/or metal oxide particles on a surface of a base material (1) to form a dispersion layer (2d);
a drying step of drying the dispersion layer (2d) to form a structure with a dried coating (10), the structure having the base material (1) and the dried coating (2e) disposed on the base material (1);
a laser light irradiation step of irradiating the dried coating (2e) with laser light to form a metal wire (2g); and
a development step of developing and removing a region of the dried coating other than the metal wire by a developer (3a), wherein

the development step comprises a first development process to develop and remove a region of the dried coating other than the metal wire by a first developer,
the first developer comprises a solvent and an additive (A);
the solvent is an organic solvent, water, or a mixture thereof;
the organic solvent is one or more selected from the group consisting of an alcohol solvent, a ketone solvent, an ester solvent, an amine solvent, and an ether solvent;
the additive (A) comprises a phosphorus-containing organic compound; and
the additive (A) in the first developer has a concentration of 0.01% by mass or greater and 20% by mass or less, and wherein
the development step further comprises a second development process of developing and removing a region of the dried coating other than the metal wire by a second developer after the first development process, and
the metal particles and/or the metal oxide particles have a higher solubility in the second developer than in the first developer.

2. The method for manufacturing a metal wire according to claim 1, wherein the surface of the base material (1) has an arithmetic average surface roughness Ra of 70 nm or more and 1000 nm or less.

3. The method for manufacturing a metal wire according to claim 1 or 2, wherein the dispersion further comprises an additive (B).

4. The method for manufacturing a metal wire according to any one of claims 1 to 3, wherein the dispersion comprises copper oxide particles, and wherein copper oxide has a higher solubility in the second developer than in the first developer.

5. The method for manufacturing a metal wire according to any one of claims 1 to 4, wherein the dispersion comprises copper oxide particles, and wherein solubility of copper oxide in the second developer is 0.1 mg/L or more and 10000 mg/L or less.

6. The method for manufacturing a metal wire according to any one of claims 1 to 5, wherein the second developer comprises one or more organic solvents selected from the group consisting of an amine solvent, an alcohol solvent, a hydrocarbon solvent, an ester solvent, and a ketone solvent.

7. The method for manufacturing a metal wire according to claim 6, wherein the amine solvent comprises diethylenetriamine and/or 2-aminoethanol.

8. The method for manufacturing a metal wire according to any one of claims 1 to 7, wherein the first developer comprises water and/or an alcohol solvent.

9. The method for manufacturing a metal wire according to any one of claims 1 to 8, wherein

the first developer comprises an additive (A) and the dispersion comprises an additive (B), and
a main component of the additive (A) and a main component of the additive (B) are identical.

10. The method for manufacturing a metal wire according to any one of claims 1 to 9, wherein a difference in surface free energy of the first developer and surface free energy of the dispersion is 0 mN/m or more and 50 mN/m or less.

11. The method for manufacturing a metal wire according to any one of claims 1 to 10, wherein

the method further comprises a regenerated dispersion preparation step of using a used developer (3b) to prepare a regenerated dispersion (3c) after the development step, and
the regenerated dispersion is used as the dispersion.

12. A kit, comprising a structure with a dried coating (10) a first developer and a second developer, wherein

the structure with a dried coating (10) has a base material (1) and a dried coating (2e) comprising (i) metal particles and/or metal oxide particles and (ii) an additive (B) disposed on a surface of the base material (1);
the first developer comprises a solvent, which is an organic solvent, water, or a mixture thereof, and an additive (A);

the organic solvent is one or more selected from the group consisting of an alcohol solvent, a ketone solvent, an ester solvent, an amine solvent, and an ether solvent;
the additive (A) comprises a phosphorus-containing organic compound; and
the additive (A) in the first developer has a concentration of 0.01% by mass or greater and 20% by mass or less, and wherein
the metal particles and/or the metal oxide particles have a higher solubility in the second developer than in the first developer.

**13.** The kit according to claim 12, wherein the additive (B) comprises a dispersant and/or a reductant.

**14.** The kit according to claim 12 or 13, wherein a surface of the structure with a dried coating (10) has an arithmetic average surface roughness Ra of 70 nm or more and 1000 nm or less.

**15.** The kit according to any one or claims 12 to 14, wherein the dried coating (2e) comprises copper oxide particles, and wherein copper oxide has a higher solubility in the second developer than in the first developer.

**16.** The kit according to any one of claims 12 to 15, wherein the dried coating (2e) comprises copper oxide particles, and wherein solubility of copper oxide in the second developer is 0.1 mg/L or more and 10000 mg/L or less.

**17.** The kit according to any one of claims 12 to 16, wherein the second developer comprises one or more organic solvents selected from the group consisting of an amine solvent, an alcohol solvent, a hydrocarbon solvent, an ester solvent, and a ketone solvent.

**18.** The kit according to any one of claims 12 to 17, wherein the first developer comprises water and/or an alcohol solvent.

**19.** The kit according to any one of claims 12 to 18, wherein

the first developer comprises an additive (A) and the dried coating (2e) comprises an additive (B), and
a main component of the additive (A) and a main component of the additive (B) are identical.

**20.** A metal wire manufacturing system, comprising:

an application mechanism for applying a dispersion comprising metal particles and/or metal oxide particles and an additive (B) on a surface of a base material (1) to form a dispersion layer (2d);
a drying mechanism for drying the dispersion layer (2d) to form a structure with a dried coating (10), the structure having the base material (1) and the dried coating (2e) disposed on the base material (1);
a laser light irradiation mechanism for irradiating the dried coating (2e) with laser light to form a metal wire (2g);
a first development mechanism for developing and removing a region of the dried coating other than the metal wire by a first developer; and
a second development mechanism for developing and removing a region of the dried coating other than the metal wire by a second developer, wherein
the first developer comprises a solvent, which is an organic solvent, water, or a mixture thereof, and an additive (A), wherein
the organic solvent is one or more selected from the group consisting of an alcohol solvent, a ketone solvent, an ester solvent, an amine solvent, and an ether solvent;
the additive (A) comprises a phosphorus-containing organic compound; and
the additive (A) in the first developer has a concentration of 0.01% by mass or greater and 20% or mass or less, and wherein
the metal particles and/or the metal oxide particles have a higher solubility in the second developer than in the first developer.

**21.** The metal wire manufacturing system according to claim 20, wherein the dispersion comprises copper oxide particles, and wherein copper oxide has a higher solubility in the second developer than in the first developer.

**22.** The metal wire manufacturing system according to claim 20 or 21, wherein the first developer comprises water and/or an alcohol solvent.

**23.** The metal wire manufacturing system according to any one of claims 20 to 22, wherein a main component of the

additive (A) and a main component of the additive (B) are identical.

## Patentansprüche

1. Verfahren zum Herstellen eines Metalldrahts, Folgendes umfassend:

   einen Aufbringungsschritt eines Aufbringens einer Dispersion, die Metallpartikel und/oder Metalloxidpartikel umfasst, auf einer Oberfläche eines Basismaterials (1), um eine Dispersionsschicht (2d) auszubilden;
   einen Trocknungsschritt eines Trocknens der Dispersionsschicht (2d), um eine Struktur mit einer getrockneten Beschichtung (10) auszubilden, wobei die Struktur das Basismaterial (1) aufweist und die getrocknete Beschichtung (2e) auf dem Basismaterial (1) angeordnet ist;
   einen Laserlichtbestrahlungsschritt eines Bestrahlens der getrockneten Beschichtung (2e) mit Laserlicht, um einen Metalldraht (2g) auszubilden; und
   einen Entwicklungsschritt eines Entwickelns und Entfernens eines anderen Bereichs der getrockneten Beschichtung als des Metalldrahts durch einen Entwickler (3a), wobei
   der Entwicklungsschritt einen ersten Entwicklungsprozess umfasst, um einen anderen Bereich der getrockneten Beschichtung als den Metalldraht durch einen ersten Entwickler zu entwickeln und zu entfernen,
   der erste Entwickler ein Lösemittel und einen Zusatzstoff (A) umfasst;
   das Lösemittel ein organisches Lösemittel, Wasser oder eine Mischung davon ist;
   das organische Lösemittel mindestens eines ist, das ausgewählt ist aus der Gruppe, bestehend aus einem Alkohol-Lösemittel, einem Keton-Lösemittel, einem Ester-Lösemittel, einem Amin-Lösemittel und einem Ether-Lösemittel;
   der Zusatzstoff (A) eine Phosphor enthaltende organische Verbindung umfasst; und
   der Zusatzstoff (A) in dem ersten Entwickler eine Konzentration von 0,01 Masse-% oder mehr und von 20 Masse-% oder weniger aufweist und wobei
   der Entwicklungsschritt weiterhin einen zweiten Entwicklungsprozess eines Entwickelns und Entfernens eines anderen Bereichs der getrockneten Beschichtung als des Metalldrahts durch einen zweiten Entwickler nach dem ersten Entwicklungsprozess umfasst und
   die Metallpartikel und/oder die Metalloxidpartikel in dem zweiten Entwickler eine höhere Löslichkeit aufweisen als in dem ersten Entwickler.

2. Verfahren zum Herstellen eines Metalldrahts nach Anspruch 1, wobei die Oberfläche des Basismaterials (1) eine arithmetische mittlere Oberflächenrauigkeit Ra von 70 nm oder mehr und von 1000 nm oder weniger aufweist.

3. Verfahren zum Herstellen eines Metalldrahts nach Anspruch 1 oder 2, wobei die Dispersion weiterhin einen Zusatzstoff (B) umfasst.

4. Verfahren zum Herstellen eines Metalldrahts nach einem der Ansprüche 1 bis 3, wobei die Dispersion Kupferoxidpartikel umfasst und wobei Kupferoxid eine höhere Löslichkeit in dem zweiten Entwickler aufweist als in dem ersten Entwickler.

5. Verfahren zum Herstellen eines Metalldrahts nach einem der Ansprüche 1 bis 4, wobei die Dispersion Kupferoxidpartikel umfasst und wobei eine Löslichkeit von Kupferoxid in dem zweiten Entwickler 0,1 mg/l oder mehr und 10000 mg/l oder weniger ist.

6. Verfahren zum Herstellen eines Metalldrahts nach einem der Ansprüche 1 bis 5, wobei der zweite Entwickler mindestens ein organisches Lösemittel umfasst, das ausgewählt ist aus der Gruppe, bestehend aus einem Amin-Lösemittel, einem Alkohol-Lösemittel, einem Kohlenwasserstoff-Lösemittel, einem Ester-Lösemittel und einem Keton-Lösemittel.

7. Verfahren zum Herstellen eines Metalldrahts nach Anspruch 6, wobei das Amin-Lösemittel Diethylentriamin und/oder 2-Aminoethanol umfasst.

8. Verfahren zum Herstellen eines Metalldrahts nach einem der Ansprüche 1 bis 7, wobei der erste Entwickler Wasser und/oder ein Alkohol-Lösemittel umfasst.

9. Verfahren zum Herstellen eines Metalldrahts nach einem der Ansprüche 1 bis 8, wobei

der erste Entwickler einen Zusatzstoff (A) umfasst und die Dispersion einen Zusatzstoff (B) umfasst und eine Hauptkomponente des Zusatzstoffs (A) und eine Hauptkomponente des Zusatzstoffs (B) identisch sind.

**10.** Verfahren zum Herstellen eines Metalldrahts nach einem der Ansprüche 1 bis 9, wobei eine Differenz der freien Oberflächenenergie des ersten Entwicklers und der freien Oberflächenenergie der Dispersion 0 mN/m oder mehr und 50 mN/m oder weniger ist.

**11.** Verfahren zum Herstellen eines Metalldrahts nach einem der Ansprüche 1 bis 10, wobei

das Verfahren weiterhin einen Zubereitungsschritt für regenerierte Dispersion eines Verwendens eines gebrauchten Entwicklers (3b) umfasst, um nach dem Entwicklungsschritt eine regenerierte Dispersion (3c) herzustellen, und
die regenerierte Dispersion als die Dispersion verwendet wird.

**12.** Kit, eine Struktur mit einer getrockneten Beschichtung (10), einem ersten Entwickler und einem zweiten Entwickler umfassend, wobei

die Struktur mit einer getrockneten Beschichtung (10) ein Basismaterial (1) und eine getrocknete Beschichtung (2e) aufweist, die (i) Metallpartikel und/oder Metalloxidpartikel und (ii) einen Zusatzstoff (B) umfasst, der auf einer Oberfläche des Basismaterials (1) angeordnet ist;
der erste Entwickler ein Lösemittel, das ein organisches Lösemittel, Wasser oder eine Mischung davon ist, und einen Zusatzstoff (A) umfasst;
das organische Lösemittel mindestens eines ist, das ausgewählt ist aus der Gruppe, bestehend aus einem Alkohol-Lösemittel, einem Keton-Lösemittel, einem Ester-Lösemittel, einem Amin-Lösemittel und einem Ether-Lösemittel;
der Zusatzstoff (A) eine Phosphor enthaltende organische Verbindung umfasst; und
der Zusatzstoff (A) in dem ersten Entwickler eine Konzentration von 0,01 Masse-% oder mehr und von 20 Masse-% oder weniger aufweist und wobei
die Metallpartikel und/oder die Metalloxidpartikel in dem zweiten Entwickler eine höhere Löslichkeit aufweisen als in dem ersten Entwickler.

**13.** Kit nach Anspruch 12, wobei der Zusatzstoff (B) ein Dispergiermittel und/oder ein Reduktionsmittel umfasst.

**14.** Kit nach Anspruch 12 oder 13, wobei eine Oberfläche der Struktur mit einer getrockneten Beschichtung (10) eine arithmetische mittlere Oberflächenrauigkeit Ra von 70 nm oder mehr und von 1000 nm oder weniger aufweist.

**15.** Kit nach einem der Ansprüche 12 bis 14, wobei die getrocknete Beschichtung (2e) Kupferoxidpartikel umfasst und wobei Kupferoxid eine höhere Löslichkeit in dem zweiten Entwickler aufweist als in dem ersten Entwickler.

**16.** Kit nach einem der Ansprüche 12 bis 15, wobei die getrocknete Beschichtung (2e) Kupferoxidpartikel umfasst und wobei eine Löslichkeit von Kupferoxid in dem zweiten Entwickler 0,1 mg/l oder mehr und 10000 mg/l oder weniger ist.

**17.** Kit nach einem der Ansprüche 12 bis 16, wobei der zweite Entwickler mindestens ein organisches Lösemittel umfasst, das ausgewählt ist aus der Gruppe, bestehend aus einem Amin-Lösemittel, einem Alkohol-Lösemittel, einem Kohlenwasserstoff-Lösemittel, einem Ester-Lösemittel und einem Keton-Lösemittel.

**18.** Kit nach einem der Ansprüche 12 bis 17, wobei der erste Entwickler Wasser und/oder ein Alkohol-Lösemittel umfasst.

**19.** Kit nach einem der Ansprüche 12 bis 18, wobei

der erste Entwickler einen Zusatzstoff (A) umfasst und die getrocknete Beschichtung (2e) einen Zusatzstoff (B) umfasst und
eine Hauptkomponente des Zusatzstoffs (A) und eine Hauptkomponente des Zusatzstoffs (B) identisch sind.

**20.** Metalldrahtherstellungssystem, Folgendes umfassend:

einen Aufbringungsmechanismus zum Aufbringen einer Dispersion, die Metallpartikel und/oder Metalloxidpartikel und einen Zusatzstoff (B) umfasst, auf einer Oberfläche eines Basismaterials (1), um eine Dispersionsschicht (2d) auszubilden;
einen Trocknungsmechanismus zum Trocknen der Dispersionsschicht (2d), um eine Struktur mit einer getrockneten Beschichtung (10) auszubilden, wobei die Struktur das Basismaterial (1) aufweist und die getrocknete Beschichtung (2e) auf dem Basismaterial (1) angeordnet ist;
einen Laserlichtbestrahlungsmechanismus zum Bestrahlen der getrockneten Beschichtung (2e) mit Laserlicht, um einen Metalldraht (2g) auszubilden;
einen ersten Entwicklungsmechanismus zum Entwickeln und Entfernen eines anderen Bereichs der getrockneten Beschichtung als des Metalldrahts durch einen ersten Entwickler; und
einen zweiten Entwicklungsmechanismus zum Entwickeln und Entfernen eines anderen Bereichs der getrockneten Beschichtung als des Metalldrahts durch einen zweiten Entwickler, wobei
der erste Entwickler ein Lösemittel, das ein organisches Lösemittel, Wasser oder eine Mischung davon ist, und einen Zusatzstoff (A) umfasst, wobei
das organische Lösemittel mindestens eines ist, das ausgewählt ist aus der Gruppe, bestehend aus einem Alkohol-Lösemittel, einem Keton-Lösemittel, einem Ester-Lösemittel, einem Amin-Lösemittel und einem Ether-Lösemittel;
der Zusatzstoff (A) eine Phosphor enthaltende organische Verbindung umfasst; und
der Zusatzstoff (A) in dem ersten Entwickler eine Konzentration von 0,01 Masse-% oder mehr und von 20 Masse-% oder weniger aufweist und wobei
die Metallpartikel und/oder die Metalloxidpartikel in dem zweiten Entwickler eine höhere Löslichkeit aufweisen als in dem ersten Entwickler.

**21.** Metalldrahtherstellungssystem nach Anspruch 20, wobei die Dispersion Kupferoxidpartikel umfasst und wobei Kupferoxid eine höhere Löslichkeit in dem zweiten Entwickler aufweist als in dem ersten Entwickler.

**22.** Metalldrahtherstellungssystem nach Anspruch 20 oder 21, wobei der erste Entwickler Wasser und/oder ein Alkohol-Lösemittel umfasst.

**23.** Metalldrahtherstellungssystem nach einem der Ansprüche 20 bis 22, wobei eine Hauptkomponente des Zusatzstoffs (A) und eine Hauptkomponente des Zusatzstoffs (B) identisch sind.

## Revendications

**1.** Procédé de fabrication d'un fil métallique, comprenant :

une étape d'application consistant à appliquer une dispersion comprenant des particules métalliques et/ou des particules d'oxyde métallique sur une surface d'un matériau de base (1) pour former une couche de dispersion (2d) ;
une étape de séchage consistant à sécher la couche de dispersion (2d) pour former une structure dotée d'un revêtement séché (10), la structure ayant le matériau de base (1) et le revêtement séché (2e) disposé sur le matériau de base (1) ;
une étape d'irradiation par lumière laser consistant à irradier le revêtement séché (2e) avec une lumière laser pour former un fil métallique (2g) ; et
une étape de développement consistant à développer et éliminer une zone du revêtement séché autre que le fil métallique par un développeur (3a), dans lequel
l'étape de développement comprend un premier processus de développement pour développer et éliminer une zone du revêtement séché autre que le fil métallique au moyen d'un premier développeur,
le premier développeur comprend un solvant et un additif (A) ;
le solvant est un solvant organique, de l'eau ou un mélange correspondant ;
le solvant organique est un ou plusieurs solvants choisis dans le groupe constitué par un solvant de type alcool, un solvant de type cétone, un solvant de type ester, un solvant de type amine et un solvant de type éther ;
l'additif (A) comprend un composé organique contenant du phosphore ; et
l'additif (A) dans le premier développeur a une concentration de 0,01 % en masse ou plus et de 20 % en masse ou moins, et dans lequel
l'étape de développement comprend en outre un second processus de développement consistant à développer et éliminer une zone du revêtement séché autre que le fil métallique par un second développeur après le premier processus de développement, et
les particules métalliques et/ou les particules d'oxyde métallique présentent une solubilité plus élevée dans le

second développeur que dans le premier développeur.

2. Procédé de fabrication d'un fil métallique selon la revendication 1, dans lequel la surface du matériau de base (1) a une rugosité de surface moyenne arithmétique Ra de 70 nm ou plus et de 1 000 nm ou moins.

3. Procédé de fabrication d'un fil métallique selon la revendication 1 ou 2, dans lequel la dispersion comprend en outre un additif (B).

4. Procédé de fabrication d'un fil métallique selon l'une quelconque des revendications 1 à 3, dans lequel la dispersion comprend des particules d'oxyde de cuivre, et dans lequel l'oxyde de cuivre a une solubilité plus élevée dans le second développeur que dans le premier développeur.

5. Procédé de fabrication d'un fil métallique selon l'une quelconque des revendications 1 à 4, dans lequel la dispersion comprend des particules d'oxyde de cuivre, et dans lequel la solubilité de l'oxyde de cuivre dans le second développeur est de 0,1 mg/L ou plus et de 10 000 mg/L ou moins.

6. Procédé de fabrication d'un fil métallique selon l'une quelconque des revendications 1 à 5, dans lequel le second développeur comprend un ou plusieurs solvants organiques choisis dans le groupe constitué par un solvant de type amine, un solvant de type alcool, un solvant de type hydrocarbure, un solvant de type ester et un solvant de type cétone.

7. Procédé de fabrication d'un fil métallique selon la revendication 6, dans lequel le solvant de type amine comprend la diéthylènetriamine et/ou le 2-aminoéthanol.

8. Procédé de fabrication d'un fil métallique selon l'une quelconque des revendications 1 à 7, dans lequel le premier développeur comprend de l'eau et/ou un solvant de type alcool.

9. Procédé de fabrication d'un fil métallique selon l'une quelconque des revendications 1 à 8, dans lequel

le premier développeur comprend un additif (A) et la dispersion comprend un additif (B), et
un composant principal de l'additif (A) et un composant principal de l'additif (B) sont identiques.

10. Procédé de fabrication d'un fil métallique selon l'une quelconque des revendications 1 à 9, dans lequel une différence d'énergie libre de surface du premier développeur et d'énergie libre de surface de la dispersion est de 0 mN/m ou plus et de 50 mN/m ou moins.

11. Procédé de fabrication d'un fil métallique selon l'une quelconque des revendications 1 à 10, dans lequel

le procédé comprend en outre une étape de préparation de dispersion régénérée consistant à utiliser un développeur usagé (3b) pour préparer une dispersion régénérée (3c) après l'étape de développement, et
la dispersion régénérée est utilisée comme dispersion.

12. Kit, comprenant une structure dotée d'un revêtement séché (10), un premier développeur et un second développeur, dans lequel

la structure dotée d'un revêtement séché (10) comprend un matériau de base (1) et un revêtement séché (2e) comprenant (i) des particules métalliques et/ou des particules d'oxyde métallique et (ii) un additif (B) disposé sur une surface du matériau de base (1) ;
le premier développeur comprend un solvant, qui est un solvant organique, de l'eau ou un mélange correspondant, et un additif (A) ;
le solvant organique est un ou plusieurs solvants choisis dans le groupe constitué par un solvant de type alcool, un solvant de type cétone, un solvant de type ester, un solvant de type amine et un solvant de type éther ;
l'additif (A) comprend un composé organique contenant du phosphore ; et
l'additif (A) dans le premier développeur a une concentration de 0,01 % en masse ou plus et de 20 % en masse ou moins, et dans lequel
les particules métalliques et/ou les particules d'oxyde métallique présentent une solubilité plus élevée dans le second développeur que dans le premier développeur.

**13.** Kit selon la revendication 12, dans lequel l'additif (B) comprend un dispersant et/ou un réducteur.

**14.** Kit selon la revendication 12 ou 13, dans lequel une surface de la structure dotée d'un revêtement séché (10) a une rugosité de surface moyenne arithmétique Ra de 70 nm ou plus et de 1 000 nm ou moins.

**15.** Kit selon l'une quelconque des revendications 12 à 14, dans lequel le revêtement séché (2e) comprend des particules d'oxyde de cuivre, et dans lequel l'oxyde de cuivre a une solubilité plus élevée dans le second développeur que dans le premier développeur.

**16.** Kit selon l'une quelconque des revendications 12 à 15, dans lequel le revêtement séché (2e) comprend des particules d'oxyde de cuivre, et dans lequel la solubilité de l'oxyde de cuivre dans le second développeur est de 0,1 mg/L ou plus et de 10 000 mg/L ou moins.

**17.** Kit selon l'une quelconque des revendications 12 à 16, dans lequel le second développeur comprend un ou plusieurs solvants organiques choisis dans le groupe constitué par un solvant de type amine, un solvant de type alcool, un solvant de type de type hydrocarbure, un solvant de type ester et un solvant de type cétone.

**18.** Kit selon l'une quelconque des revendications 12 à 17, dans lequel le premier développeur comprend de l'eau et/ou un solvant de type alcool.

**19.** Kit selon l'une quelconque des revendications 12 à 18, dans lequel

le premier développeur comprend un additif (A) et le revêtement séché (2e) comprend un additif (B), et
un composant principal de l'additif (A) et un composant principal de l'additif (B) sont identiques.

**20.** Système de fabrication de fils métalliques, comprenant :

un mécanisme d'application pour appliquer une dispersion comprenant des particules métalliques et/ou des particules d'oxyde métallique et un additif (B) sur une surface d'un matériau de base (1) pour former une couche de dispersion (2d) ;
un mécanisme de séchage pour sécher la couche de dispersion (2d) afin de former une structure dotée d'un revêtement séché (10), la structure ayant le matériau de base (1) et le revêtement séché (2e) disposé sur le matériau de base (1) ;
un mécanisme d'irradiation par de la lumière laser pour irradier le revêtement séché (2e) avec de la lumière laser pour former un fil métallique (2g) ;
un premier mécanisme de développement pour développer et éliminer une zone du revêtement séché autre que le fil métallique par un premier développeur ; et
un second mécanisme de développement pour développer et éliminer une zone du revêtement séché autre que le fil métallique par un second développeur, dans lequel
le premier développeur comprend un solvant, qui est un solvant organique, de l'eau ou un mélange de ceux-ci, et un additif (A), dans lequel
le solvant organique est un ou plusieurs solvants choisis dans le groupe constitué par un solvant de type alcool, un solvant de type cétone, un solvant de type ester, un solvant de type amine et un solvant de type éther ;
l'additif (A) comprend un composé organique contenant du phosphore ; et
l'additif (A) dans le premier développeur a une concentration de 0,01 % en masse ou plus et de 20 % en masse ou moins, et
les particules métalliques et/ou les particules d'oxyde métallique présentent une solubilité plus élevée dans le second développeur que dans le premier développeur.

**21.** Système de fabrication de fils métalliques selon la revendication 20, dans lequel la dispersion comprend des particules d'oxyde de cuivre, et dans lequel l'oxyde de cuivre a une solubilité plus élevée dans le second développeur que dans le premier développeur.

**22.** Système de fabrication de fils métalliques selon la revendication 20 ou 21, dans lequel le premier développeur comprend de l'eau et/ou un solvant de type alcool.

**23.** Système de fabrication de fils métalliques selon l'une quelconque des revendications 20 à 22, dans lequel un composant principal de l'additif (A) et un composant principal de l'additif (B) sont identiques.

FIG. 1

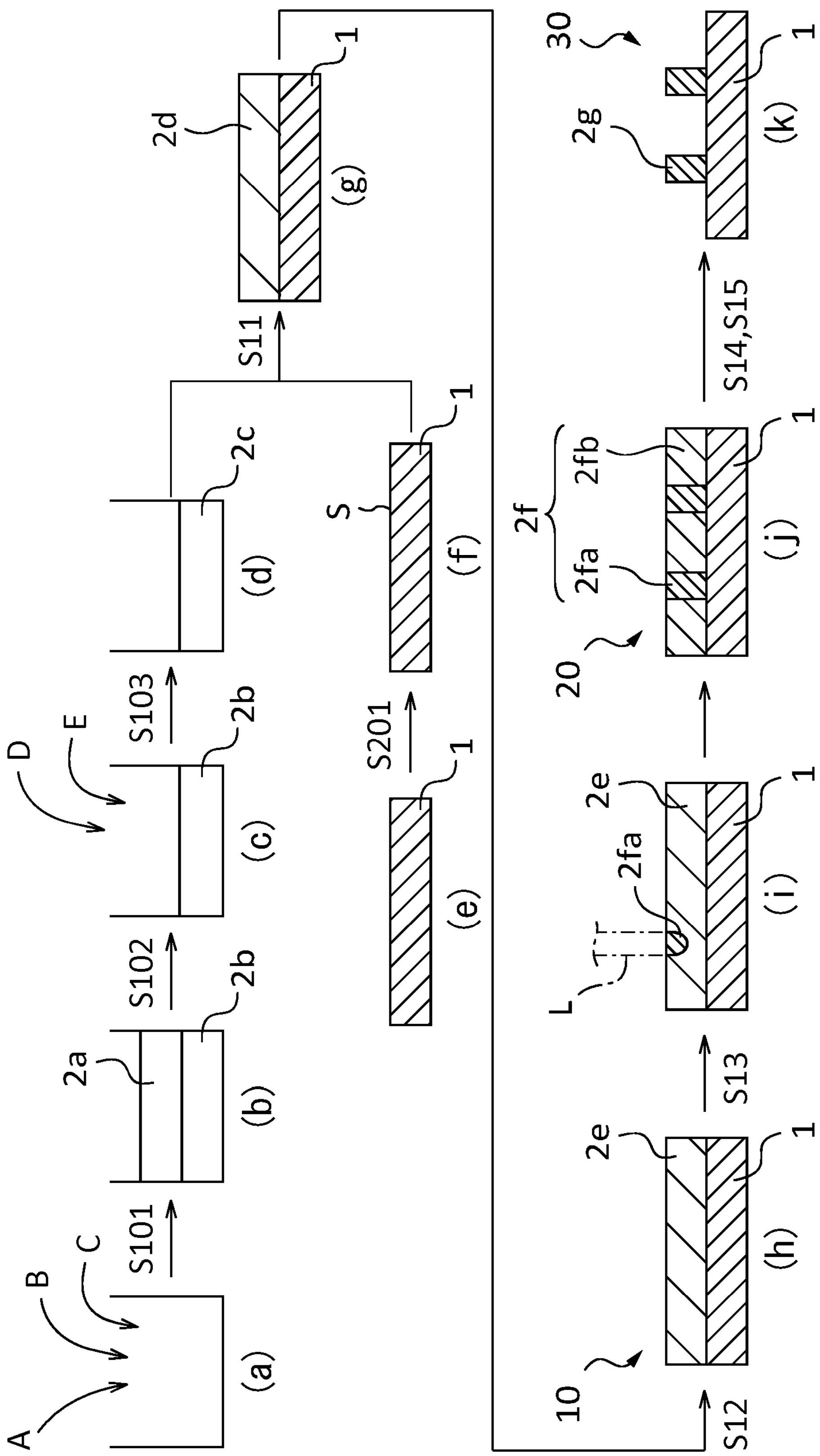
A
B
C
S101
2a
2b
S102
D
E
2b
S103
2c
S11
2d
1
S201
S
1
1
(a)
(b)
(c)
(d)
(e)
(f)
(g)
10
S12
2e
1
(h)
S13
L
2fa
2e
1
(i)
20
2f
2fa
2fb
1
(j)
S14,S15
30
2g
1
(k)

FIG. 2

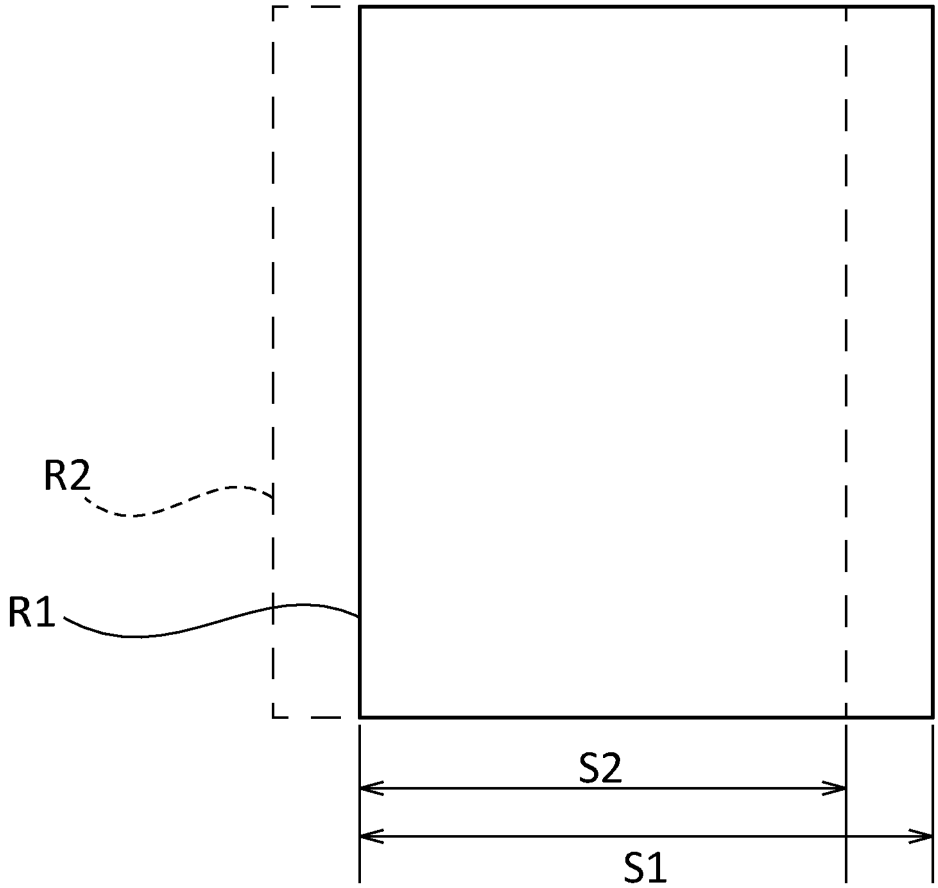


FIG. 3

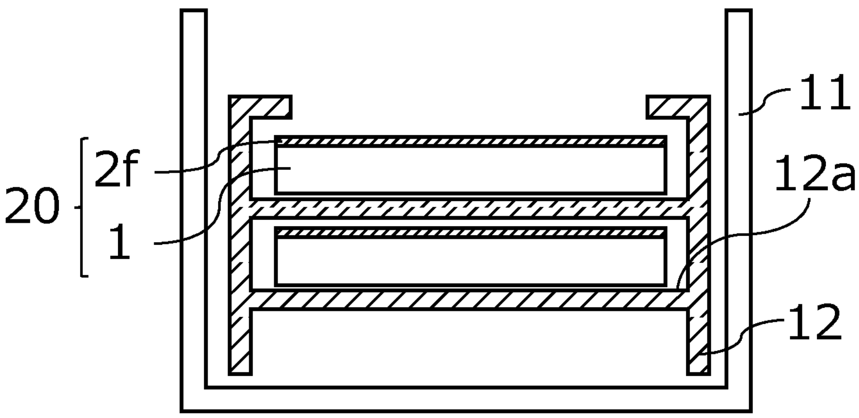

FIG. 4

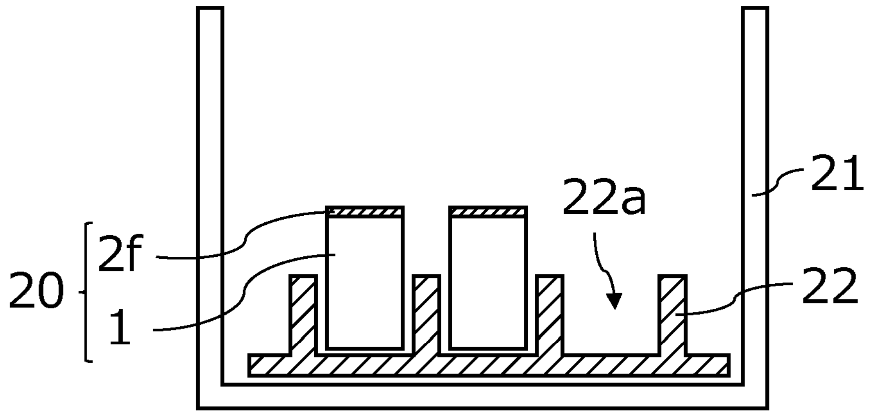


FIG. 5

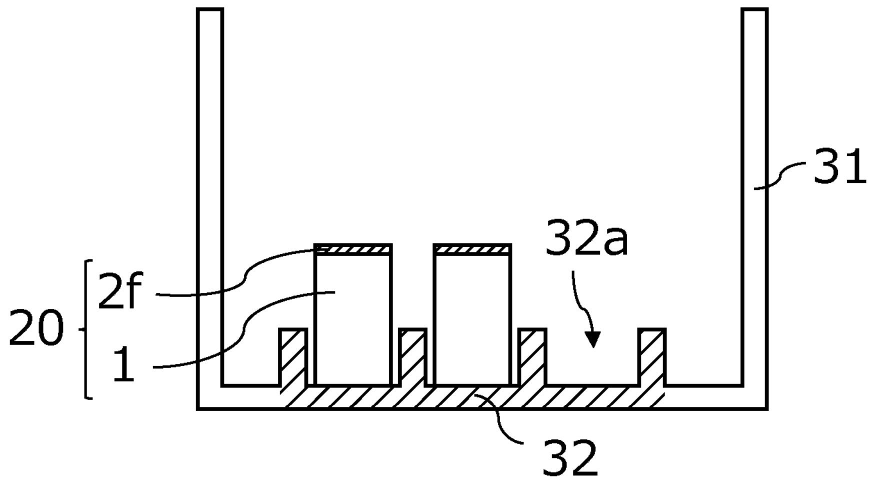

FIG. 6

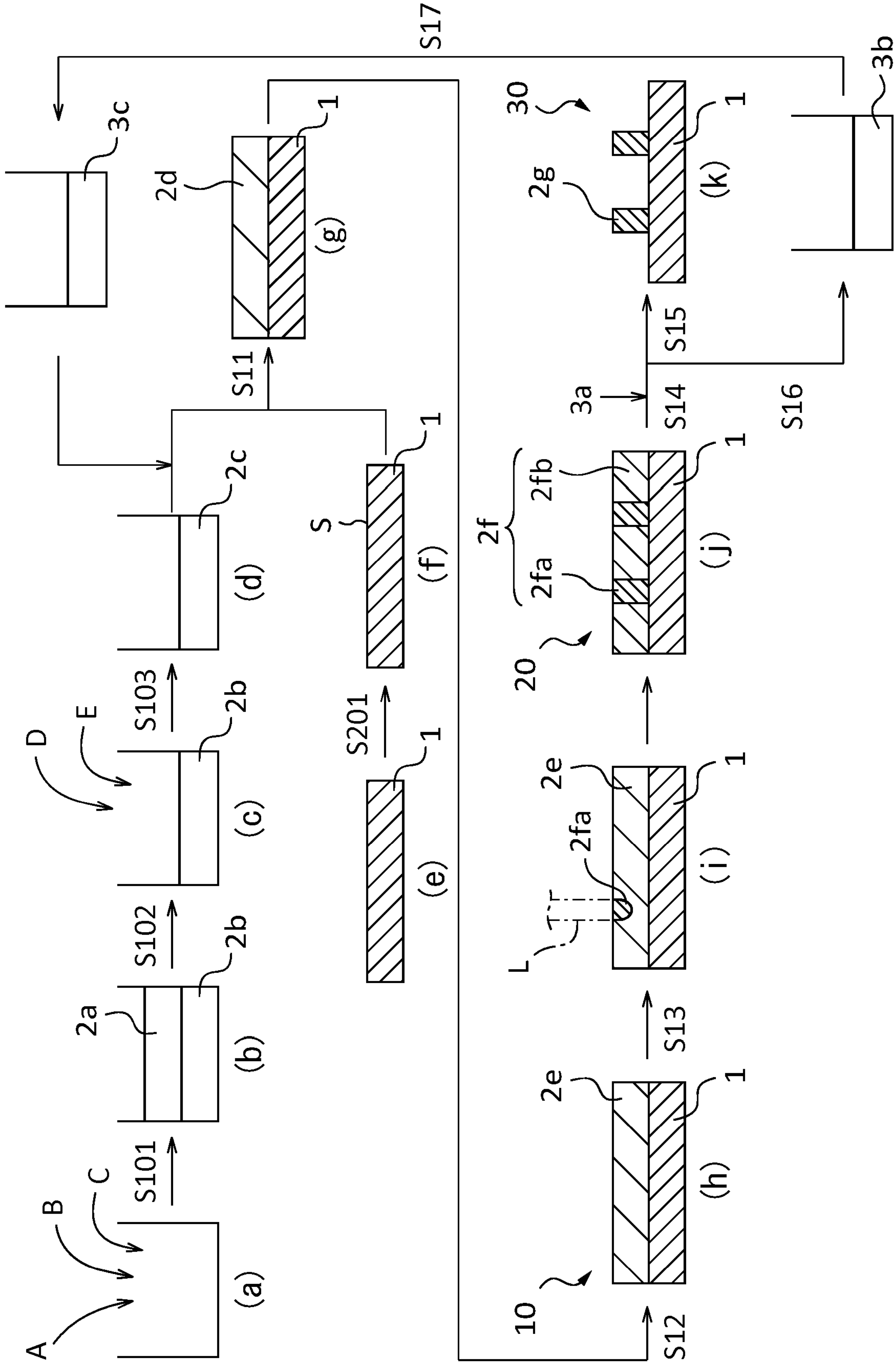

A
B
C
(a)
S101
2a
2b
(b)
S102
D
E
2b
(c)
S103
2c
(d)
3c
S17
(e)
1
S201
S
1
(f)
S11
2d
1
(g)
10
S12
2e
1
(h)
S13
L
2fa
2e
1
(i)
20
2f
2fa
2fb
1
(j)
3a
S14
S15
S16
30
2g
1
(k)
3b

FIG. 7

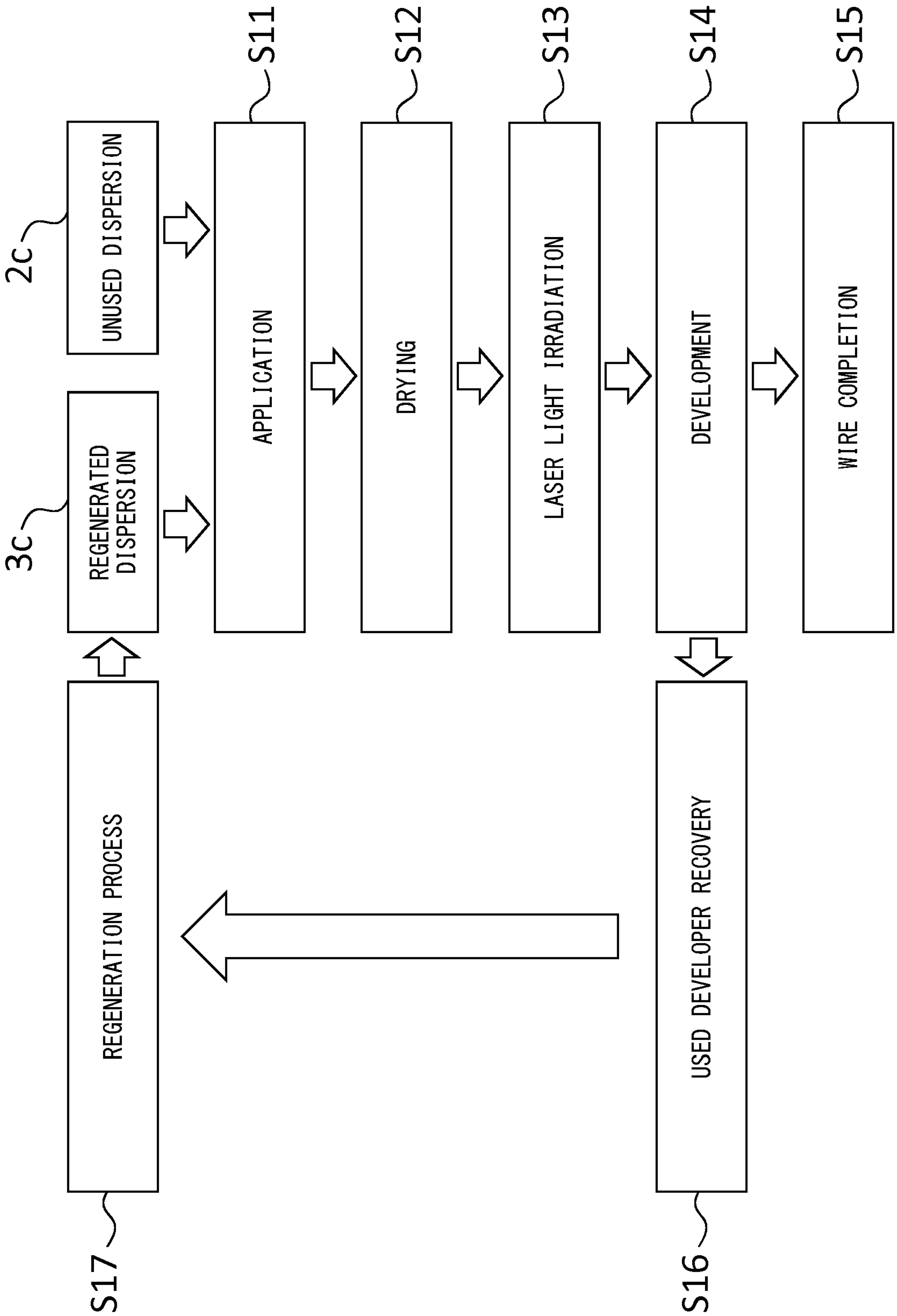

S11
S12
S13
S14
S15
2c
UNUSED DISPERSION
3c
REGENERATED DISPERSION
APPLICATION
DRYING
LASER LIGHT IRRADIATION
DEVELOPMENT
WIRE COMPLETION
REGENERATION PROCESS
USED DEVELOPER RECOVERY
S17
S16

FIG. 8

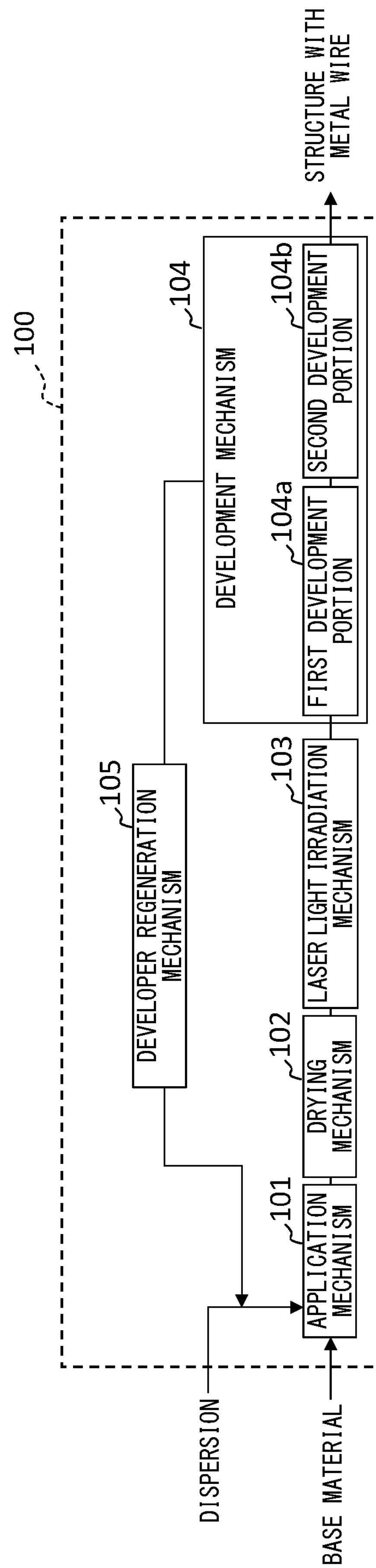
100
DISPERSION
BASE MATERIAL
APPLICATION MECHANISM
101
DRYING MECHANISM
102
LASER LIGHT IRRADIATION MECHANISM
103
DEVELOPMENT MECHANISM
104
FIRST DEVELOPMENT PORTION
104a
SECOND DEVELOPMENT PORTION
104b
DEVELOPER REGENERATION MECHANISM
105
STRUCTURE WITH METAL WIRE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020113706 A
- US 10015887 B2
- US 2015245479 A1
- WO 2019022230 A1
- WO 2010024385 A
- JP 5037126 A


### Non-patent literature cited in the description


- *Angewandte Chemie International Edition*, 2001, vol. 2 (40), 359
- *Journal of American Chemical Society*, 1999, vol. 121, 11595